(19) **Europäisches Patentamt / European Patent Office / Office européen des brevets**

(11) **EP 4 525 025 A1**

(12) **EUROPEAN PATENT APPLICATION**
published in accordance with Art. 153(4) EPC

(43) Date of publication:
**19.03.2025 Bulletin 2025/12**

(21) Application number: **23823161.7**

(22) Date of filing: **13.06.2023**

(51) International Patent Classification (IPC):
**H01L 21/335** (2006.01)   **H01L 29/778** (2006.01)
**H01L 29/36** (2006.01)

(52) Cooperative Patent Classification (CPC):
**H10D 30/01; H10D 30/47; H10D 62/60;**
**H10D 62/824; H10D 62/85; H10D 62/854**

(86) International application number:
**PCT/CN2023/100027**

(87) International publication number:
**WO 2023/241593 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.06.2022 CN 202210682633**

(71) Applicant: **Huawei Technologies Co., Ltd.
Shenzhen, Guangdong 518129 (CN)**

(72) Inventors:
• **ZHENG, Dingheng**
 **Shenzhen, Guangdong 518129 (CN)**
• **XUE, Pan**
 **Shenzhen, Guangdong 518129 (CN)**
• **WEI, Wei**
 **Shenzhen, Guangdong 518129 (CN)**
• **ZHANG, Yawen**
 **Shenzhen, Guangdong 518129 (CN)**

(74) Representative: **Pfenning, Meinig & Partner mbB
Patent- und Rechtsanwälte
Theresienhöhe 11a
80339 München (DE)**

(54) **RADIO FREQUENCY SEMICONDUCTOR DEVICE, ELECTRONIC DEVICE, AND PREPARATION METHOD FOR RADIO FREQUENCY SEMICONDUCTOR DEVICE**

(57) Embodiments of this application provide a radio frequency semiconductor device, an electronic device, and a preparation method for a radio frequency semiconductor device, and relate to the field of semiconductor technologies. A radio frequency semiconductor device for implementing a low radio frequency loss is provided. The radio frequency semiconductor device includes a substrate, and a nucleation layer, a channel layer, and a barrier layer that are sequentially stacked on the substrate, where the nucleation layer, the channel layer, and the barrier layer all contain an element in group IIIA; and the nucleation layer further contains a P-type impurity, the P-type impurity contains at least one element in group II and/or IVA, and the nucleation layer includes at least two stacked layers. At least two nucleation layers containing a P-type impurity are introduced, so as to suppress formation of a parasitic channel in a substrate containing silicon, and reduce a radio frequency loss of the radio frequency semiconductor device.

FIG. 13

EP 4 525 025 A1

## Description

This application claims priority to Chinese Patent Application No. 202210682633.X, filed with the China National Intellectual Property Administration on June 16, 2022 and entitled "RADIO FREQUENCY SEMICONDUCTOR DEVICE, ELECTRONIC DEVICE, AND PREPARATION METHOD FOR RADIO FREQUENCY SEMICONDUCTOR DEVICE", which is incorporated herein by reference in its entirety.

## TECHNICAL FIELD

This application relates to the field of semiconductor technologies, and in particular, to a radio frequency semiconductor device, an electronic device having the radio frequency semiconductor device, and a preparation method for the radio frequency semiconductor device.

## BACKGROUND

With the development of the fifth-generation mobile communications technology (5th generation of wireless communications technologies, 5G), the radio frequency communications field requires a higher frequency, a higher voltage, a higher output power, and higher efficiency for semiconductor devices.

Semiconductor devices prepared based on compound semiconductor materials, for example, gallium nitride (gallium nitride, GaN)-based high electron mobility transistors (high electron mobility transistor, HEMT), are increasingly widely used in fields such as high-power radio frequency devices and high-voltage-resistant switch devices due to characteristics of high thermal conductivity, high breakdown field strength, and high saturation electron mobility, for example, are widely used in systems such as radar, wireless communications, navigation, satellite communications, and electronic countermeasure equipment.

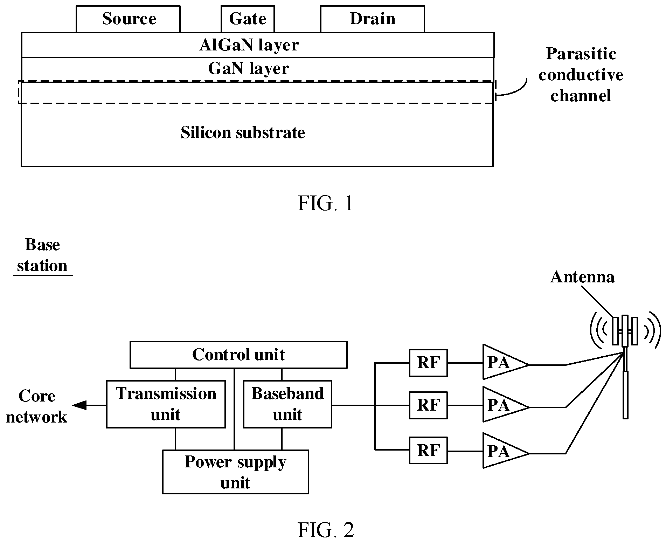

FIG. 1 is a diagram of a structure of a radio frequency semiconductor device. As shown in FIG. 1, the radio frequency semiconductor device includes a silicon substrate, a GaN layer formed above the silicon substrate, an aluminum gallium nitride (AlGaN) layer formed above the GaN layer, and a source, a drain, and a gate formed above the AlGaN layer, or some other functional film layer structures may be stacked between the silicon substrate and the GaN layer, or between the AlGaN layer and an electrode (including the source, the drain, and the gate), or between the GaN layer and the AlGaN layer.

For a radio frequency application, a key requirement of the radio frequency semiconductor device is to reduce a conduction loss, that is, a radio frequency loss, during radio frequency operation. For example, when the radio frequency semiconductor device is applied to a radio frequency power amplifier (power amplifier, PA), a low radio frequency loss can improve an output power, a power gain, efficiency, and the like during operation of the power amplifier. However, in the structure shown in FIG. 1, a parasitic conductive channel (also referred to as a parasitic channel) is easily formed on a surface layer of the silicon substrate, and the parasitic conductive channel causes a radio frequency loss, reducing operation performance of the radio frequency semiconductor.

Therefore, how to provide a radio frequency semiconductor device with a low radio frequency loss is a technical problem to be urgently resolved at present.

## SUMMARY

This application provides a radio frequency semiconductor device, an electronic device having the radio frequency semiconductor device, and a preparation method for the radio frequency semiconductor device. By providing a new type of radio frequency semiconductor device, a low radio frequency loss is achieved.

To achieve the foregoing objectives, the following technical solutions are used in embodiments of this application.

According to one aspect, this application provides a radio frequency semiconductor device. For example, the radio frequency semiconductor device may be a gallium nitride (gallium nitride, GaN)-based high electron mobility transistor (high electron mobility transistor, HEMT).

The radio frequency semiconductor device includes: a substrate, a nucleation layer, a channel layer, and a barrier layer, where the substrate contains silicon, the nucleation layer, the channel layer, and the barrier layer are sequentially stacked on the substrate, and the nucleation layer, the channel layer, and the barrier layer all contain a group IIIA nitride. The nucleation layer includes a first nucleation layer and a second nucleation layer that are stacked in a first direction, the first nucleation layer is formed on the substrate, the second nucleation layer is formed on the first nucleation layer, both the first nucleation layer and the second nucleation layer contain a P-type impurity, and the P-type impurity contains at least one element in group II and/or IVA; and a concentration of the P-type impurity in the first nucleation layer is greater than a concentration of the P-type impurity in the second nucleation layer; and/or the P-type impurity in the first nucleation layer is different from the P-type impurity in the second nucleation layer. That is, in some embodiments, the concentration of the P-type impurity in the first nucleation layer is greater than the concentration of the P-type impurity in the second nucleation layer. In some other embodiments, the P-type impurity in the first nucleation layer is different from the P-type impurity in the second nucleation layer. For example, when the first nucleation layer and the second nucleation layer contain only one type of P-type impurity, the involved P-type impurities are different. For another example, when the first nucleation layer and the second nucleation layer each include at least two types of P-type impurities, at least some of the P-type impurities are different. In some other embodiments, not only the concentration of the P-type impurity in the first nucleation layer is greater than the concentration of the P-type impurity in the second nucleation layer, but also the P-type impurity in the first nucleation layer is different from the P-type impurity in the second nucleation layer.

In the radio frequency semiconductor device provided in this application, the nucleation layer includes the first nucleation layer and the second nucleation layer that are stacked in the first direction, and both the first nucleation layer and the second nucleation layer further contain the P-type impurity. In this way, an energy band structure between the nucleation layer and the substrate of an acceptor suppresses formation of an N-type parasitic channel of an inversion layer on the surface layer of the substrate, thereby reducing a conductive capability of the substrate, and reducing a radio frequency loss of the radio frequency semiconductor device.

In addition, in this application, the concentration of the P-type impurity in the first nucleation layer is greater than the concentration of the P-type impurity in the second nucleation layer. That is, the first nucleation layer containing a relatively high-concentration P-type impurity is disposed closer to the substrate than the second nucleation layer containing a relatively low-concentration P-type impurity. In this way, the first nucleation layer can suppress formation of the N-type parasitic channel of the inversion layer on the surface layer of the substrate, and the parasitic channel is not generated in the nucleation layer because a high-concentration P-type impurity is doped in the second nucleation layer, thereby further reducing the radio frequency loss of the radio frequency semiconductor device.

In a possible implementation, along the first direction, a thickness of the first nucleation layer is less than a thickness of the second nucleation layer.

In a possible implementation, the thickness $d_1$ of the first nucleation layer is 1 nm$\leq d_1 \leq$100 nm; and the thickness $d_2$ of the second nucleation layer is 100 nm$\leq d_2 \leq$250 nm.

Certainly, in some other structures, along a stacking direction, the thickness of the first nucleation layer may be greater than or equal to the thickness of the second nucleation layer.

In a possible implementation, a dislocation density of the second nucleation layer is less than a dislocation density of the first nucleation layer.

The second nucleation layer is disposed farther away from the substrate than the first nucleation layer, and the dislocation density of the second nucleation layer is lower than the dislocation density of the first nucleation layer. Therefore, when a subsequent film layer structure, for example, a channel layer, is prepared, lattices of the channel layer can be arranged more neatly, thereby improving electron mobility of the channel layer.

In a possible implementation, both the P-type impurity in the first nucleation layer and the P-type impurity in the second nucleation layer contain at least two elements.

In a possible implementation, a full width at half maximum of a rocking curve of the nucleation layer is less than or equal to 800 arc seconds.

Compared with an existing nucleation layer whose full width at half maximum of a rocking curve is greater than 1000 arc seconds, the radio frequency semiconductor device provided in this application has a lower dislocation density, thereby improving performance and reliability of the device.

In a possible implementation, the concentrations p of P-type impurities in the first nucleation layer and the second nucleation layer are both $1\times10^{15}$ cm$^3\leq\rho\leq1\times10^{20}$ cm$^{-3}$.

In a possible implementation, the concentration of the P-type impurity in the first nucleation layer is $\rho_1$, and the concentration of the P-type impurity in the second nucleation layer is $\rho_2$, where $\rho_1/\rho_2>10$.

In a possible implementation, the concentration $\rho_1$ of the P-type impurity in the first nucleation layer is $1\times10^{17}$ cm$^{-3}\leq\rho\leq1\times10^{20}$ cm$^{-3}$, and the concentration $\rho_2$ of the P-type impurity in the second nucleation layer is $1\times10^{15}$ cm$^{-3}\leq\rho\leq1\times10^{18}$ cm$^{-3}$.

In a possible implementation, the P-type impurity includes at least one of beryllium, magnesium, calcium, zinc, carbon, and silicon.

In a possible implementation, the P-type impurity in the first nucleation layer includes magnesium, and the P-type impurity in the second nucleation layer includes at least two of magnesium, carbon, and silicon.

In a possible implementation, the group IIIA nitride in the first nucleation layer is the same as the group IIIA nitride in the second nucleation layer.

From a process perspective, it is easier to prepare the first nucleation layer and the second nucleation layer by using the same group IIIA nitride.

In a possible implementation, both the first nucleation layer and the second nucleation layer include aluminum nitride AIN.

The P-type impurity is doped in a group IIIA nitride nucleation layer containing an aluminum nitride AIN material. In the group IIIA nitride nucleation layer containing the aluminum nitride AIN material, a lattice arrangement is not very neat due to lattice mismatch with the substrate, that is, a large quantity of dislocations exist. A purpose of disposing the group IIIA nitride nucleation layer is to reduce a dislocation density of the channel layer, so that a lattice arrangement of the channel layer growing on the group IIIA nitride nucleation layer is neater, and the channel layer has better performance. In this embodiment of this application, when the P-type impurity is doped in the group IIIA nitride nucleation layer whose lattices are not very neat, the lattice arrangement in the group IIIA nitride nucleation layer is not severely damaged, and therefore, performance of the group IIIA nitride nucleation layer is slightly affected.

In a possible implementation, the channel layer includes a gallium nitride GaN material.

It may be understood in this way that the group IIIA nitride nucleation layer containing the aluminum nitride AlN material can ensure that a lattice arrangement in a group IIIA nitride channel layer including the gallium nitride GaN material is neater, thereby improving mobility of two-dimensional electron gas (two-dimensional electron gas, 2DEG) in the group IIIA nitride channel layer.

In a possible implementation, the barrier layer includes an aluminum gallium nitride AlGaN material.

For example, a group IIIA nitride barrier layer is disposed above the group IIIA nitride channel layer, and the group IIIA nitride barrier layer is used to cooperate with the group IIIA nitride channel layer, so as to generate 2DEG through a polarization effect in an area where the group IIIA nitride channel layer is connected to the group IIIA nitride barrier layer, a channel that provides a conduction current.

In a possible implementation, the radio frequency semiconductor device further includes a diffusion barrier layer, and along the first direction, the diffusion barrier layer is formed between the substrate and the first nucleation layer.

By disposing the diffusion barrier layer between the substrate and the first nucleation layer, the diffusion barrier layer may be used to suppress diffusion of a group IIIA element in the nucleation layer or another film layer structure located on the nucleation layer to the substrate, so as to suppress formation of the P-type parasitic channel on the surface layer of the substrate, thereby further reducing the conductive capability of the substrate.

According to another aspect, this application further provides a preparation method for a radio frequency semiconductor device, where the preparation method includes:

forming a first nucleation layer on a substrate containing silicon, where the first nucleation layer includes a group IIIA nitride doped with a P-type impurity; and
forming a second nucleation layer on the first nucleation layer, where the second nucleation layer includes a group IIIA nitride doped with a P-type impurity;
where the P-type impurity contains at least one element in group II and/or IVA; and
a concentration of the P-type impurity in the first nucleation layer is greater than a concentration of the P-type impurity in the second nucleation layer; and/or the P-type impurity in the first nucleation layer is different from the P-type impurity in the second nucleation layer.

In the preparation method for a radio frequency semiconductor device provided in this application, because both the group IIIA nitride in the first nucleation layer and the group IIIA nitride in the second nucleation layer are doped with the P-type impurity, the first nucleation layer and the second nucleation layer containing the P-type impurity can suppress formation of an N-type parasitic channel of an inversion layer on a surface layer of the substrate, so as to reduce a conductivity capability of the substrate and reduce a radio frequency loss of a prepared radio frequency semiconductor device.

In addition, in the preparation method of this application, the concentration of the P-type impurity in the first nucleation layer is greater than the concentration of the P-type impurity in the second nucleation layer. That is, the first nucleation layer containing a relatively high-concentration P-type impurity is disposed closer to the substrate than the second nucleation layer containing a relatively low-concentration P-type impurity. In this way, the first nucleation layer can suppress formation of the N-type parasitic channel of the inversion layer on the surface layer of the substrate, and the parasitic channel is not generated in the nucleation layer because a high-concentration P-type impurity is doped in the second nucleation layer, so as to further reduce the radio frequency loss of the radio frequency semiconductor device.

In a possible implementation, when the first nucleation layer and the second nucleation layer are formed, a growth temperature for forming the first nucleation layer is less than a growth temperature for forming the second nucleation layer.

When the growth temperature of the first nucleation layer is less than the growth temperature of the second nucleation layer, this helps prevent the first nucleation layer from generating an excessively large tension stress, thereby reducing a risk of generating a crack.

In a possible implementation, a precursor for preparing the first nucleation layer and/or the second nucleation layer includes at least one of diethyl beryllium, bis-cyclopentadienyl magnesium, dimethyl zinc, calcium diisopropyl dithiocarbamate, methane, ethylene, silane, or disilane.

In a possible implementation, before the forming a first nucleation layer on a substrate containing silicon, the production method further includes: forming a diffusion barrier layer on the substrate containing silicon, to form the first nucleation layer on the diffusion barrier layer.

In a selectable process flow, the diffusion barrier layer may be first formed on the substrate, and then the first nucleation layer is formed on the diffusion barrier layer. That is, diffusion of the group IIIA element in the nucleation layer to the substrate may be suppressed by using the diffusion barrier layer, so as to form a P-type parasitic channel having a conductive capability in the substrate.

In a possible implementation, when the first nucleation layer and the second nucleation layer are formed, the first nucleation layer and the second nucleation layer are prepared by using a same group IIIA nitride. For example, the first nucleation layer and the second nucleation layer may be prepared by using aluminum nitride AlN.

Therefore, a main component of the first nucleation layer is the same as a main component of the second nucleation layer.

According to still another aspect, this application further provides a radio frequency semiconductor device, where the radio frequency semiconductor device includes a substrate, a diffusion barrier layer, a nucleation layer, a channel layer, and a barrier layer, the substrate contains silicon, the diffusion barrier layer, the nucleation layer, the channel layer, and the barrier layer are sequentially stacked on the substrate, and the nucleation layer, the channel layer, and the barrier layer all contain a group IIIA nitride. The nucleation layer further contains a P-type impurity, and the P-type impurity contains at least one element in group II and/or IVA.

In the radio frequency semiconductor device provided in this application, because the diffusion barrier layer is formed between the substrate and the nucleation layer, the diffusion barrier layer can prevent diffusion of a group IIIA element in the nucleation layer or another film layer structure located on the nucleation layer to the substrate, so as to suppress formation of a P-type parasitic channel on a surface layer of the substrate, thereby reducing a conductivity capability of the substrate.

In addition, in the radio frequency semiconductor device, the nucleation layer further contains the P-type impurity, and an energy band structure between the nucleation layer and the substrate of an acceptor suppresses formation of an N-type parasitic channel of an inversion layer on the surface layer of the substrate, thereby reducing the conductive capability of the substrate, and reducing a radio frequency loss of the radio frequency semiconductor device.

In a possible implementation, a concentration p of the P-type impurity in the nucleation layer is: $1\times10^{15}$ cm$^3\leq\rho\leq1\times10^{20}$ cm$^{-3}$.

In a possible implementation, a thickness d of the nucleation layer is 1 nm$\leq$d$\leq$300 nm.

For example, the thickness d of the nucleation layer may be equal to 150 nm.

In a possible implementation, the P-type impurity in the nucleation layer includes at least one of magnesium, carbon, and silicon.

In a possible implementation, the nucleation layer includes a first nucleation layer and a second nucleation layer that are stacked along a first direction, the first nucleation layer is formed on the diffusion barrier layer, the second nucleation layer is formed on the first nucleation layer, and both the first nucleation layer and the second nucleation layer contain a P-type impurity.

That is, the radio frequency semiconductor device may include at least two nucleation layers.

In a possible implementation, a concentration of the P-type impurity in the first nucleation layer is greater than a concentration of the P-type impurity in the second nucleation layer; and/or the P-type impurity in the first nucleation layer is different from the P-type impurity in the second nucleation layer.

The concentration of the P-type impurity in the first nucleation layer is greater than the concentration of the P-type impurity in the second nucleation layer. That is, the first nucleation layer containing a relatively high-concentration P-type impurity is disposed closer to the substrate than the second nucleation layer containing a relatively low-concentration P-type impurity. In this way, the first nucleation layer can suppress formation of the N-type parasitic channel of the inversion layer on the surface layer of the substrate, and a parasitic channel of high conductivity is not generated in the nucleation layer because a high-concentration P-type impurity is doped in the second nucleation layer, so as to further reduce the radio frequency loss of the radio frequency semiconductor device.

In a possible implementation, the concentration p of the P-type impurity in the first nucleation layer is $1\times10^{17}$ cm$^{-3}\leq\rho\leq1\times10^{20}$ cm$^{-3}$, and the concentration p of the P-type impurity in the second nucleation layer is $1\times10^{15}$ cm$^3\leq\rho\leq1\times10^{18}$ cm$^{-3}$.

In a possible implementation, the P-type impurity in the first nucleation layer includes magnesium, and the P-type impurity in the second nucleation layer includes at least two of magnesium, carbon, and silicon.

In a possible implementation, the group IIIA nitride in the first nucleation layer is the same as the group IIIA nitride in the second nucleation layer.

According to yet another aspect, this application further provides a preparation method for a radio frequency semiconductor device, where the preparation method includes:

forming a diffusion barrier layer on a substrate containing silicon; and
forming a nucleation layer on the diffusion barrier layer, where the nucleation layer further contains a P-type impurity, and the P-type impurity contains at least one element in group II and/or IVA.

That is, in the preparation method involved in this application, the diffusion barrier layer can prevent diffusion of a group IIIA element in the nucleation layer to the substrate, so as to suppress formation of a P-type parasitic channel on a surface layer of the substrate, thereby reducing a conductive capability of the substrate. In addition, the nucleation layer further contains the P-type impurity, and an energy band structure between the nucleation layer and the substrate of an acceptor suppresses formation of an N-type parasitic channel of an inversion layer on the surface layer of the substrate, thereby reducing the conductive capability of the substrate, and reducing a radio frequency loss of the radio frequency semiconductor device.

In a possible implementation, the forming a nucleation layer includes: forming a first nucleation layer on the substrate containing silicon, and then forming a second nucleation layer on the first nucleation layer, where a concentration of a P-type impurity in the first nucleation layer is greater than a concentration of a P-type impurity in the second nucleation layer; and/or the P-type impurity in the first nucleation layer is different from the P-type impurity in the second nucleation layer.

In a possible implementation, a precursor for preparing the first nucleation layer and/or the second nucleation layer includes at least one of diethyl beryllium, bis-cyclopentadienyl magnesium, dimethyl zinc, calcium diisopropyl dithiocarbamate, methane, ethylene, silane, or disilane.

According to yet another aspect, this application further provides an electronic device, including a circuit board and the radio frequency semiconductor device in any one of the foregoing implementations or a radio frequency semiconductor device prepared in any one of the foregoing implementations, and the circuit board is electrically connected to the radio frequency semiconductor device.

The electronic device provided in this embodiment of this application includes the foregoing radio frequency semiconductor device. Therefore, the electronic device provided in this embodiment of this application and the radio frequency semiconductor device in the foregoing technical solution can resolve a same technical problem, and achieve a same expected effect.

## BRIEF DESCRIPTION OF DRAWINGS

FIG. 1 is a schematic diagram of a structure of a radio frequency semiconductor device in the conventional technology;

FIG. 2 is a schematic diagram of a partial structure of a base station;

FIG. 3 is a schematic exploded diagram of a partial structure of a mobile phone;

FIG. 4 is a schematic diagram of a partial structure of some electronic devices such as a base station or a mobile phone;

FIG. 5 is a schematic diagram of a structure of a radio frequency semiconductor device;

FIG. 6 is a schematic diagram of forming a P-type parasitic channel in the structure shown in FIG. 5;

FIG. 7 is a schematic diagram of a structure of a radio frequency semiconductor device according to an embodiment of this application;

FIG. 8 is a schematic diagram of a structure used to show an electrode of a radio frequency semiconductor device according to an embodiment of this application;

FIG. 9 is a schematic diagram of a structure of a radio frequency semiconductor device according to an embodiment of this application;

FIG. 10a is an energy band diagram of each of AlN and Si in a radio frequency semiconductor device according to an embodiment of this application;

FIG. 10b is an energy band diagram of each of AlN of an n-type conductivity type and Si in a radio frequency semiconductor device according to an embodiment of this application;

FIG. 10c is an energy band diagram of a heterojunction formed by AlN of an n-type conductivity type and Si in a radio frequency semiconductor device according to an embodiment of this application;

FIG. 11 is a schematic diagram of a structure of a radio frequency semiconductor device according to an embodiment of this application;

FIG. 12a is an energy band diagram of each of AlN of a P-type conductivity type and Si in a radio frequency semiconductor device according to an embodiment of this application;

FIG. 12b is an energy band diagram of a heterojunction formed by AlN of a P-type conductivity type and Si in a radio frequency semiconductor device according to an embodiment of this application;

FIG. 13 is a schematic diagram of a structure of a radio frequency semiconductor device according to an embodiment of this application;

FIG. 14 is a schematic diagram of a structure of a radio frequency semiconductor device according to an embodiment of this application;

FIG. 15 is a schematic diagram of a structure of a radio frequency semiconductor device according to an embodiment of this application;

FIG. 16 is a schematic diagram of a structure of a radio frequency semiconductor device according to an embodiment of this application;

FIG. 17 is a schematic diagram of a structure of a radio frequency semiconductor device according to an embodiment of this application;

FIG. 18 is a schematic diagram of a structure of a radio frequency semiconductor device according to an embodiment of this application;

FIG. 19 is a schematic diagram of a structure of a radio frequency semiconductor device according to an embodiment of this application;

FIG. 20 is a schematic diagram of a structure of a radio frequency semiconductor device according to an embodiment of this application;

FIG. 21 is a schematic diagram of a structure of a radio frequency semiconductor device according to an embodiment of this application;

FIG. 22 is a block diagram of a flowchart of a method for forming a radio frequency semiconductor device according to an embodiment of this application;

FIG. 23a to FIG. 23e are corresponding schematic diagrams of structures after steps in a method for preparing a radio frequency semiconductor device are completed according to an embodiment of this application;

FIG. 24 is a block diagram of a flowchart of a method for forming a radio frequency semiconductor device according to an embodiment of this application; and

FIG. 25a to FIG. 25f are corresponding schematic diagrams of structures after steps in a method for preparing a radio frequency semiconductor device are completed according to an embodiment of this application.

Reference numerals:

11-middle frame; 110-edge frame; 111-bearing plate; 12-rear housing;
13-display screen;
100-circuit board;
101-radio frequency semiconductor device; 102-first electrical connection structure;
103-package substrate;
200-second electrical connection structure;
1-substrate;
2-diffusion barrier layer;
31-nucleation layer;
311-first nucleation layer; 312-second nucleation layer; 313-third nucleation layer;
32-channel layer;
33-barrier layer;
34-stress buffer layer;
35-isolation layer;
36-cap layer
41-source;
42-gate; and
43-drain.

## DESCRIPTION OF EMBODIMENTS

Before embodiments involved in this application are described, some technical terms related to the embodiments of this application are first described. Details are as follows:

Dislocation density (dislocation density): A large quantity of dislocations exist in a common crystal, and the quantity of these dislocations is represented by a dislocation density. The dislocation density may be defined as a total length of dislocation lines contained in a unit volume crystal.

Full width at half maximum of a rocking curve: is used to describe a size of angle divergence of a specific crystal surface in a sample. The larger the angle divergence, the larger the full width at half maximum of the rocking curve and the higher the dislocation density. On the contrary, the smaller the angle divergence, the smaller the full width at half maximum of the rocking curve and the lower the dislocation density.

Precursor: may be understood as a primitive substance used for preparing a layer of structure. For example, when an aluminum nitride (AlN) layer containing a P-type impurity is being prepared, the precursor may be diethyl beryllium, trimethyl aluminum, and ammonia gas.

Heterojunction: is a junction formed by contact between two different semiconductor materials. Lattice constants of the two materials are different, and therefore a lattice mismatch occurs.

Interface state: In a heterojunction, in addition to an interface state generated by a lattice mismatch on a contact surface of two different semiconductor materials, an interface distortion is caused by a mismatch of thermal expansion coefficients of the two materials, and an interface state is also generated.

Semiconductor heterojunction energy band diagram: shows changes in energy of a lowest conduction band value and a highest valence band value on both sides of a heterojunction interface.

Donor and acceptor: For a doped semiconductor, most electrons and holes are provided by impurities. An impurity that can provide an electron is referred to as a donor, and an impurity that can provide a hole is referred to as an acceptor.

An embodiment of this application provides an electronic device. The electronic device may include a communications device (for example, a base station or a mobile phone), a wireless charging device, a medical device, a radar, a navigation device, a radio frequency (radio frequency, RF) plasma lighting device, an RF sensing and microwave heating device, and the like. A specific form of the electronic device is not specially limited in the embodiments of this application.

The electronic device basically includes a radio frequency semiconductor device, for example, includes a power amplifier (power amplifier, PA). A main function of the PA is to amplify a radio frequency signal. Taking a base station as an example, FIG. 2 is a simple schematic diagram of a structure of a base station. The base station includes a control unit. The control unit in the base station includes a wireless transceiver, an antenna, a related signal processing circuit, and the like. The control unit mainly includes four components: a cell controller, a voice channel controller, a signaling channel controller, and a multi-path interface for extension. The control unit of the base station generally controls several base transceiver stations. Through remote commands of the transceiver stations and mobile stations, the control unit of the base station is responsible for managing all mobile communications interfaces, mainly allocating, releasing, and managing wireless channels.

Still with reference to FIG. 2, the base station further includes a transmission unit, where the transmission unit is connected to a core network, control signaling on a core network side and voice call or data service information are sent to the control unit of the base station by using the transmission unit, and the control unit processes the services.

With reference to FIG. 2, the base station further includes a baseband unit and a radio frequency (radio frequency, RF) unit. The baseband unit mainly fulfills functions such as baseband modulation and demodulation, wireless resource allocation, call processing, power control, and soft handover. The RF unit mainly fulfills conversion between an air radio frequency channel and a baseband digital channel, then a power amplifier (power amplifier, PA) amplifies a signal, and then the signal is sent by using a radio frequency feeder to an antenna for transmission. A terminal device, such as a mobile phone (mobile phone) or a tablet computer (pad), receives, by using a wireless channel, a radio wave transmitted by an antenna, and then demodulates a signal belonging to the terminal device.

Still with reference to FIG. 2, the base station further includes a power supply unit, where the power supply unit may be configured to supply power to structures such as the transmission unit, the baseband unit, and the control unit.

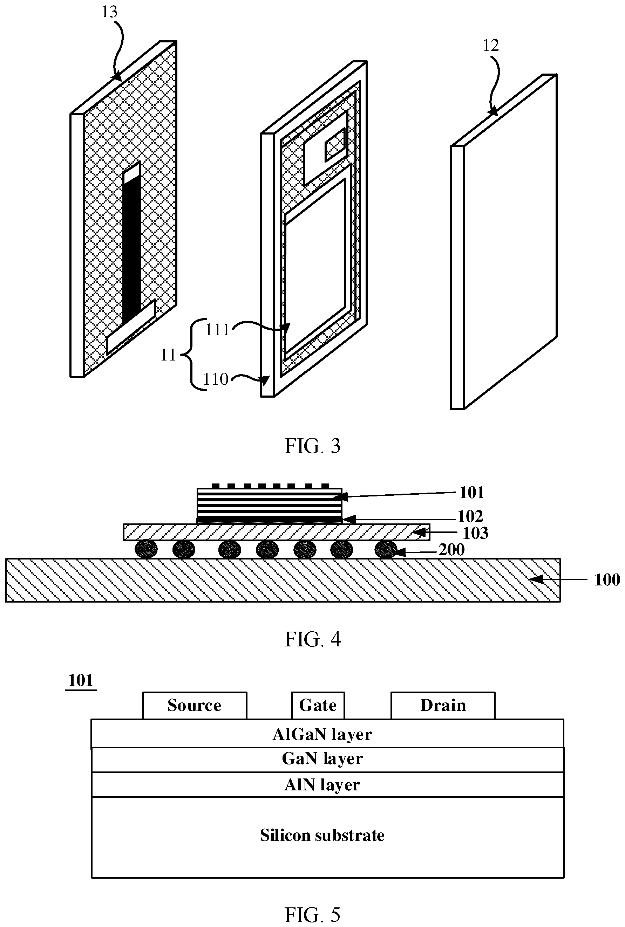

FIG. 3 is a diagram of a structure of another electronic device. A mobile phone is used as an example of the electronic device. The mobile phone may include a middle frame 11, a rear housing 12, and a display screen 13. The middle frame 11 includes a bearing plate 111 configured to bear the display screen 13, and an edge frame 110 surrounding the bearing plate 111 by one round. The bearing plate 111 bears an RF unit and a PA device. After amplifying a signal output by the RF unit, the PA device feeds the signal to an antenna in the mobile phone (for example, the antenna may be disposed along an edge of the edge frame 110), to receive and send a signal.

With the development of the fourth-generation mobile communications technology (4th generation of wireless communications technologies, 4G) to the fifth-generation mobile communications technology (5th generation of wireless communications technologies, 5G), a function requirement for the foregoing radio frequency semiconductor device is increasingly high, for example, having a higher frequency, a higher voltage, a higher output power, and higher efficiency.

Among selectable semiconductor materials, gallium nitride (GaN) becomes a key material for preparing a radio frequency semiconductor device because of its high thermal conductivity, high breakdown field strength, and high saturation electron mobility. For example, a high electron mobility transistor (high electron mobility transistor, HEMT) based on gallium nitride (gallium nitride, GaN) is prepared by using a GaN epitaxial single-crystal thin film grown on a single-crystal substrate. The single-crystal substrate generally uses a material such as a sapphire (Sapphire), silicon carbide (SiC), or silicon (Si) single crystal. For example, when the substrate uses a silicon single-crystal material, a prepared HEMT may be referred to as a gallium nitride on silicon (GaN-on-Si) HEMT device.

As shown in FIG. 4, a radio frequency semiconductor device 101 in the foregoing device is disposed on a substrate 103, and the radio frequency semiconductor device 101 is disposed on the substrate 103 by using a first electrical connection structure (for example, a metal layer) 102, so that the radio frequency semiconductor device 101 can perform signal interconnection with another electronic device on the substrate 103.

The substrate 103 is then disposed on a circuit board 100 by using a second electrical connection structure 200. For example, the circuit board 1 may be a printed circuit board (printed circuit board, PCB), and the second electrical connection structure 200 herein may be a ball grid array (ball grid array, BGA) or another electrical connection structure.

The radio frequency semiconductor device 101 shown in FIG. 4 may include a structure shown in FIG. 5. FIG. 5 is a diagram of a cross-sectional structure of the radio frequency semiconductor device 101. The radio frequency semiconductor device 101 includes: a silicon substrate, an aluminum nitride (AlN) layer formed on the silicon substrate, a GaN layer formed on the AlN layer, and an aluminum gallium nitride (AlGaN) layer formed on the GaN layer, and a source, a gate, and a drain formed above the AlGaN layer.

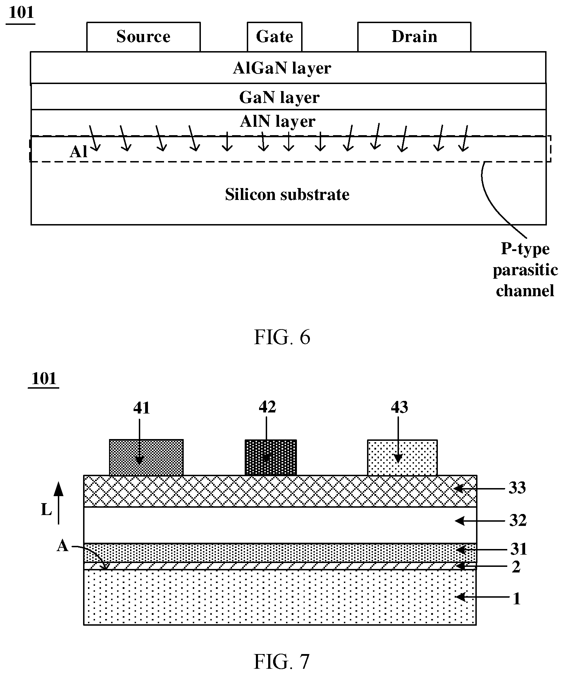

However, in the radio frequency semiconductor device 101 shown in FIG. 5, a parasitic conductive channel is easily generated on a surface layer of the silicon substrate close to the AlN layer. The parasitic conductive channel is formed mainly for the following two reasons: (1) A reaction cavity for preparing the radio frequency semiconductor device 101 contains Al and Ga residues, and after the AlN layer is produced, a decomposition product of a precursor containing Al and Ga in a subsequent high-temperature growth process is diffused to the silicon substrate, so that diffusion doping is formed on the surface layer of the silicon substrate to form a P-type parasitic channel shown in FIG. 6; (2) Because there is a difference in material characteristics between AlN and Si, energy bands of layer structures of different materials of the two are different, and an N-type parasitic channel with a high conduction loss is easily formed on the surface layer of the silicon substrate.

Regardless of whether a p-type parasitic channel is formed on the surface layer of the silicon substrate or an N-type parasitic channel is formed on the surface layer of the silicon substrate, as shown in FIG. 6, the silicon substrate generates a conductive capability, so as to generate a radio frequency loss and reduce operation performance of the radio frequency semiconductor device.

Therefore, preparation of a GaN on silicon (GaN-on-Si) semiconductor device with a low radio frequency loss is the key to realize application of a high-performance radio frequency device.

Based on this, the embodiments of this application provide some implementable radio frequency semiconductor devices. These radio frequency semiconductor devices not only can suppress formation of a P-type parasitic channel, but also can suppress formation of an N-type parasitic channel. In this way, a conduction loss during operation of the radio frequency semiconductor device can be reduced, that is, a radio frequency loss can be reduced, and an output power, a power gain, efficiency, and the like can be improved during operation of the radio frequency semiconductor device.

The following describes in detail the radio frequency semiconductor device involved in the embodiments of this application with reference to the accompanying drawings.

With reference to FIG. 7, FIG. 7 is a sectional view of a radio frequency semiconductor device 101 according to an embodiment of this application. The radio frequency semiconductor device 101 includes a substrate 1, a diffusion barrier layer 2 formed on the substrate 1, a nucleation layer 31 formed on the diffusion barrier layer 2, a channel layer 32 formed on the nucleation layer 31, and a barrier layer 33 formed on the channel layer 32. That is, film layer structures such as the diffusion barrier layer 2, the nucleation layer 31, the channel layer 32, and the barrier layer 33 are sequentially stacked on the substrate 1 along a first direction L shown in FIG. 7.

In addition, still referring to FIG. 7, the radio frequency semiconductor device 101 further includes a source (Source) 41, a gate (Gate) 42, and a drain (Drain) 43. The source (Source) 41, the gate (Gate) 42, and the drain (Drain) 43 are formed on a side that is of the barrier layer 33 and that is away from the substrate 1.

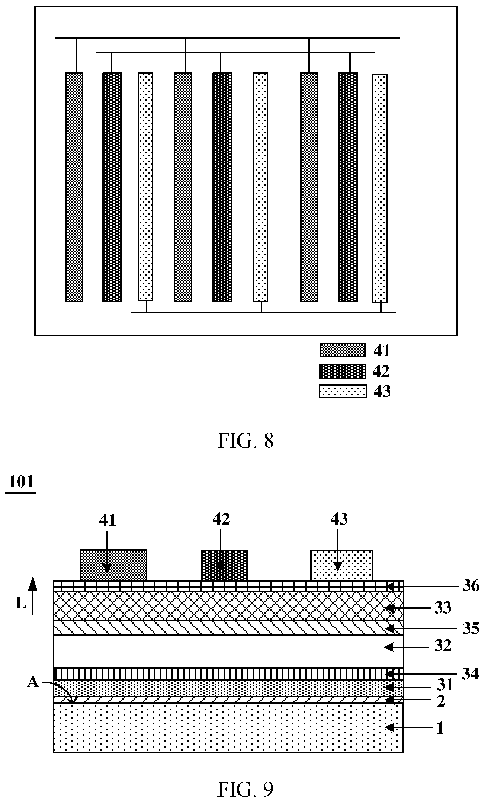

FIG. 7 shows an example in which the radio frequency semiconductor device 101 includes a group of electrodes. The group of electrodes herein includes one source 41, one gate 42, and one drain 43. In some other implementable structures, as shown in FIG. 8, FIG. 8 shows an example in which the radio frequency semiconductor device 101 includes a plurality of groups of electrodes, for example, three groups of electrodes. Sources 41 in the plurality of groups of electrodes are electrically connected to each other, gates 42 in the plurality of groups of electrodes are electrically connected to each other, and drains 43 in the plurality of groups of electrodes are electrically connected to each other.

In addition, any one of these electrodes has a same extension direction, and these electrodes may be alternately spaced apart in a direction perpendicular to the extension direction of the electrodes.

The substrate 1 may contain silicon, and the substrate 1 containing silicon may be explained in this way: As shown in FIG. 7, a surface A of the substrate 1 opposite to the diffusion barrier layer 2 may be a silicon surface. For example, in some embodiments, the substrate 1 may be a silicon wafer, and the surface A may correspond to a surface of the silicon wafer. In some other embodiments, the surface A may correspond to a silicon surface of a composite substrate (for example, including a silicon layer and one or more lower layers disposed below the silicon layer). In some other embodiments, the surface A may correspond to a surface of a silicon portion of a silicon-on-insulator substrate. In still some other embodiments, the surface A may correspond to a surface of a silicon-on-sapphire substrate. In yet some other embodiments, the surface A may correspond to a silicon surface of a separation by implantation of oxygen substrate.

In addition, the substrate 1 may be a high-resistance substrate containing silicon. For example, the high-resistance substrate containing silicon may be a substrate structure with a resistivity greater than or equal to 1000 $\Omega \cdot$cm, or may be a substrate structure with a resistivity greater than or equal to 2000 $\Omega \cdot$cm, or may be a substrate structure with a resistivity greater than or equal to 5000 $\Omega \cdot$cm.

Applying the high-resistance substrate containing silicon to a device (for example, an RF device) operating at a high frequency can improve performance of the radio frequency semiconductor device. For example, a high resistivity can reduce a substrate loss and reduce power consumption of the radio frequency semiconductor device.

Still referring to FIG. 7, in the radio frequency semiconductor device 101, the nucleation layer 31, the channel layer 32, and the barrier layer 33 that are disposed in the first direction, that is, the stacking direction L, may all contain a group IIIA nitride, that is, may be prepared by using any group IIIA nitride material. For example, the group IIIA nitride material may include one or a combination of at least two of boron nitride (BN), aluminum nitride (AlN), gallium nitride (GaN), indium nitride (InN), thallium nitride (TIN), and aluminum gallium nitride (AlGaN), or may include any alloy formed by a group IIIA element and a group VA element, for example, indium gallium nitride (InGaN), aluminum indium gallium nitride (AlInGaN), gallium arsenic phosphorus nitride (GaAsPbN), aluminum indium gallium arsenic phosphorus nitride (AlInGaAsPbN), and the like.

For example, the nucleation layer 31 may contain an aluminum nitride (AlN) material. The aluminum nitride (AlN) material may be understood in this way: The aluminum nitride (AlN) material refers to aluminum nitride (AlN) and any alloy thereof, for example, aluminum gallium nitride (AlGaN), aluminum indium nitride (AlInN), aluminum indium gallium nitride (AlInGaN), and aluminum indium gallium arsenic phosphide nitride (AlInGaAsPbN). These aluminum nitride (AlN) alloys may have high-concentration aluminum and may contain at least one of a small quantity of gallium and indium, or does not include gallium and indium, that is, an alloy concentration is smaller than the aluminum concentration.

Still referring to FIG. 7, in the radio frequency semiconductor device 101, the diffusion barrier layer 2 is formed between the substrate 1 and the nucleation layer 31 along the stacking direction P. The diffusion barrier layer 2 may be formed on the surface A of the substrate 1, that is, may directly cover the surface A of the substrate 1.

A plurality of materials are selectable for the diffusion barrier layer 2. For example, a metal (for example, Al) may be selected, or one or a combination of at least two of a silicon oxygen compound, a silicon nitrogen compound, an aluminum oxygen compound, an aluminum silicon compound, an aluminum silicon nitrogen compound, and the like may be selected.

In some process flows, for example, it may be difficult to directly perform, on the substrate 1, heterogeneous epitaxial growth for the nucleation layer 31 including AlN. The diffusion barrier layer 2 containing aluminum is first formed on the substrate 1, and a difference between a lattice of the group IIIA nitride material of the nucleation layer 31 and a lattice of the substrate 1 may be alleviated by using the diffusion barrier layer 2. It may also be understood in this way: A lattice mismatch between the substrate 1 and the aluminum nitride may be alleviated by using the diffusion barrier layer 2, so that lattices of the aluminum nitride grow more neatly.

In addition, when the nucleation layer 31 is formed on the diffusion barrier layer 2, the diffusion barrier layer 2 may further be used to suppress diffusion of the group IIIA element (for example, Al) in the nucleation layer 31 towards the substrate 1 containing silicon. Alternatively, when the channel layer 32 or the barrier layer 33 is formed on the nucleation layer 31, the diffusion barrier layer 2 may be used to suppress diffusion of the group IIIA element (for example, Al and Ga) in the channel layer 32 or the barrier layer 33 towards the substrate 1 containing silicon. In this way, concentrations of these group IIIA elements diffused to the substrate 1 can be reduced, so that the group IIIA elements diffused to the substrate 1 can be suppressed from forming a P-type parasitic channel in the substrate 1, so as to reduce a conductive capability of the substrate 1.

When the diffusion barrier layer 2 is formed on the substrate 1, the diffusion barrier layer 2 may be prepared by using a plurality of process means. For example, an ammonia gas may be pre-introduced for nitrification preprocessing, to form a silicon nitride thin film on the substrate 1 containing silicon as the diffusion barrier layer 2. For another example, an aluminum oxide thin film may be formed on the substrate 1 containing silicon by using an epitaxial growth technology as the diffusion barrier layer 2, so as to reduce the conductive capability of the substrate 1 after epitaxial growth.

Based on the foregoing description of the diffusion barrier layer 2, it may be understood that the diffusion barrier layer 2 can not only alleviate the lattice mismatch between the substrate 1 and the nucleation layer 31, so that the lattices of the nucleation layer 31 grow more neatly, and subsequently, lattices of the channel layer 32 or the barrier layer 33 can be produced in a relatively neat manner, and a dislocation density is relatively small, thereby improving an output power, a power gain, efficiency, and the like of the radio frequency semiconductor device. In addition, the diffusion barrier layer 2 may further suppress a degree of diffusion of the group IIIA element included in the nucleation layer 31, the channel layer 32, or the barrier layer 33 to the substrate 1, and suppress formation of the P-type parasitic channel in the substrate 1.

FIG. 9 is a diagram of a structure of another radio frequency semiconductor device 101 according to an embodiment of this application. Compared with the radio frequency semiconductor device 101 shown in FIG. 7, the radio frequency semiconductor device 101 shown in FIG. 9 not only includes a substrate 1, a diffusion barrier layer 2, a nucleation layer 31, a channel layer 32, and a barrier layer 33, but also includes another film layer structure. For example, still referring to FIG. 9, the radio frequency semiconductor device 101 may further include a stress buffer layer 34. The stress buffer layer 34 may be formed on a side that is of the nucleation layer 31 and that is away from the diffusion barrier layer 2, that is, may be formed on the nucleation layer 31.

The stress buffer layer 34 includes, but is not limited to, a single layer or a plurality of layers of group IIIA nitrides and a multi-element group IIIA nitride, or a superlattice structure formed thereby.

In some selectable implementations, the stress buffer layer 34 may include a compositionally graded (compositionally graded) group IIIA nitride material. For example, the stress buffer layer 34 may include $Al_xGa_{(1-x)}N$, where x may gradually decrease along a growth direction (that is, along a direction away from the substrate 1 shown in FIG. 9), for example, x may decrease from a value 1 to a value 0.

The compositionally graded stress buffer layer 34 may be graded according to the following example rule.

For example, x in a composition of $Al_xGa_{(1-x)}N$ is continuously graded from a value 1 on a surface of a lower surface B of the stress buffer layer 34 to a value 0 on an upper surface C of the stress buffer layer 34.

For another example, x in the composition of $Al_xGa_{(1-x)}N$ is discontinuously graded from the value 1 on the surface of the lower surface B of the stress buffer layer 34 to the value 0 on the upper surface C of the stress buffer layer 34. For example, discontinuous grading is performed from the surface of the lower surface B of the stress buffer layer 34 to the upper surface C of the stress buffer layer 34 by using AlN, $Al_{0.6}Ga_{0.4}N$, $Al_{0.4}Ga_{0.6}N$, and $Al_{0.2}Ga_{0.8}N$.

For another example, x in the composition of $Al_xGa_{(1-x)}N$ is graded from the value 1 on the surface of the lower surface B of the stress buffer layer 34 to the value 0 on the surface of the upper surface C of the stress buffer layer 34 in a parabolic manner, or is graded in another continuous or discontinuous grading manner.

In addition, in some selectable embodiments, a gallium nitride alloy such as $Al_xIn_yGa_{(1-x-y)}N$ or $In_yGa_{(1-y)}N$ may be selected to form. A concentration of an element of the alloy, for example, at least one of Ga, Al, and In, changes along a thickness of the stress buffer layer. For example, when the stress buffer layer has a composition of $Al_xIn_yGa_{(1-y)}N$, at least one of x and y is changeable. For another example, in some embodiments of a composition of $In_yGa_{(1-y)}N$ of the stress buffer layer, y may be changeable.

Still with reference to FIG. 9, the channel layer 32 of the radio frequency semiconductor device 101 may be formed on a side that is of the stress buffer layer 34 and that is away from the nucleation layer 31, that is, formed on the stress buffer layer 34. The channel layer 32 may contain a gallium nitride (GaN) material. As shown in FIG. 9, when the upper surface of the stress buffer layer 34 is a GaN material, and the channel layer 32 is also a GaN material, the channel layer 32 of the GaN material is generally doped (for example, doped with an element such as carbon or iron), to form a GaN layer with a high resistivity, that is, to suppress an electric leakage and increase a breakdown voltage through doping. However, the channel layer 32 of the GaN material is used to pass a current, and a GaN epitaxial layer with high quality and a low impurity is required.

The channel layer 32 may include one channel layer, or may include at least two stacked channel layers.

Still with reference to FIG. 9, the radio frequency semiconductor device 101 may further include an isolation layer 35, and the isolation layer 35 may be formed on a side that is of the channel layer 32 and that is away from the stress buffer layer 34, that is, formed on the channel layer 32.

The isolation layer 35 may contain an AlN material. A higher concentration of a two-dimensional electron gas may be generated by using a polarization effect of an AlGaN, AlN, or GaN structure, and a probability that the two-dimensional electron gas penetrates into the barrier layer is reduced. The isolation layer 35 can reduce disordered scattering of the alloy, thereby improving mobility and helping improve an output characteristic of the device.

A thickness of the isolation layer 35 may be less than or equal to 2 nm and greater than or equal to 0.1 nm.

Still with reference to FIG. 9, the barrier layer 33 in the radio frequency semiconductor device 101 may be formed on a side that is of the isolation layer 35 and that is far away from the channel layer 32, that is, formed on the isolation layer 35.

The barrier layer 33 may include, but is not limited to, a group IIIA nitride and a multi-element group IIIA nitride, such as $Al_aGa_bIn_{1-a-b}N$, where $0\leq a+b\leq 1$. In some other specific embodiments, $Al_zGa_{1-z}N$ may alternatively be selected, where $0.1<z<0.3$. In some other specific embodiments, $In_{0.17}Al_{0.83}N$ may alternatively be selected.

An aluminum content in the barrier layer 33 is different from an aluminum content in the stress buffer layer 34 and that in the channel layer 32.

A thickness of the barrier layer 33 may be less than or equal to 100 nm and greater than or equal to 5 nm, for example, may be selected to be less than or equal to 25 nm and greater than or equal to 10 nm.

The barrier layer 33 is configured to cooperate with the channel layer 32, so as to generate a two-dimensional electron gas (two-dimensional electron gas, 2DEG) channel region between the channel layer 32 and the barrier layer 33 through a polarization effect, and provide a channel for fast electron transport, so as to conduct a current.

Still with reference to FIG. 9, the radio frequency semiconductor device 101 may further include a cap layer 36, and the cap layer 36 may be formed on a side that is of the barrier layer 33 and that is away from the isolation layer 35, that is, formed on the barrier layer 33.

In some selectable embodiments, in a case of covering the cap layer 36, compared with a surface formed when the cap layer does not exist, an obtained surface form may be smoother and surface defects are fewer. In addition, using the GaN material to terminate growth of the epitaxial layer also facilitates subsequent chemical processing on a surface of the epitaxial layer.

The cap layer 36 may include but is not limited to a growing nitride or oxide layer. For example, in some embodiments, a growing GaN single-crystal layer may be selected. For another example, in some embodiments, a growing polycrystal SiNx layer may be selected.

In addition, the cap layer 36 may be monocrystalline, polycrystalline, or amorphous.

In a selectable process manner, a metal-organic vapor phase epitaxy (metal-organic vapor phase epitaxy, MOVPE) technology, also referred to as a metal-organic chemical vapor deposition (metal-organic chemical vapor deposition, MOCVD) technology, may be used as a growth technology to form, on the diffusion barrier layer 2, group IIIA nitride forming layers containing the nucleation layer 31, the channel layer 32, the barrier layer 33, the stress buffer layer 34, the isolation layer 35, and the cap layer 36. Alternatively, a molecular beam epitaxy (molecular beam epitaxy, MBE) technology may be used as a growth technology to form, on the diffusion barrier layer 2, group IIIA nitride forming layers containing the nucleation layer 31, the channel layer 32, the barrier layer 33, and the like. Certainly, another epitaxial growth technology may alternatively be used.

In some process flows, for example, when the nucleation layer 31 is grown by using the MOVPE technology, a large quantity of $NH_3$ needs to be introduced. An AlN layer grown in an atmosphere of $NH_3$ usually shows an n-type conductivity type due to existence of a defect. In addition, because a lattice constant of AlN is smaller than a lattice constant of Si, the AlN layer is subject to a relatively large tension stress and forms a relatively strong polarization effect, and thus an energy band of AlN is bent.

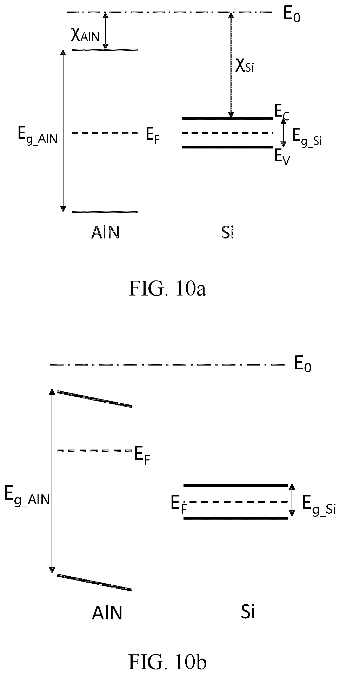

The following explains, by using semiconductor energy band diagrams shown in FIG. 10a to FIG. 10c, some phenomena presented when the nucleation layer 31 exhibits an n-type conductivity type.

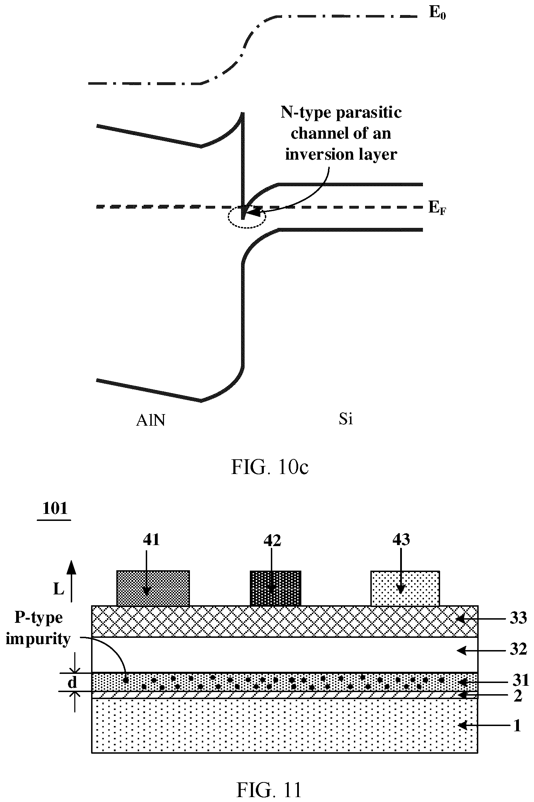

FIG. 10a is an energy band diagram of each of AlN and Si, FIG. 10b is an energy band diagram of each of AlN exhibiting an n-type conductivity type and Si, and FIG. 10c is an energy band diagram of a heterojunction formed by AlN exhibiting an n-type conductivity type and Si.

In FIG. 10a to FIG. 10c, a physical significance represented by each quantity in the energy band diagram

is as follows:

E$_0$: vacuum level. It indicates minimum energy that an electron needs to have to run out of a semiconductor into a vacuum.

E$_F$: Fermi level. For a micro-system formed by a fermion (which may be an electron, a proton, and a neutron), each fermion is in its own quantum energy state. In energy band theory, Fermi level may be considered to be a hypothetical energy level of an electron, such that at thermodynamic equilibrium this energy level would have a 50% probability of being occupied.

E$_C$: indicates the bottom of a conduction band of a band gap.

E$_V$: indicates the top of a valence band of a band gap. Eg: band gap. It is an energy difference between the top of the valence band and the bottom of the conduction band, and is a minimum average energy required to generate intrinsic excitation. For example, in FIG. 10a, Eg-AlN indicates a band gap of AlN, and Eg-Si indicates a band gap of Si. A size of the band gap determines whether a material has a semiconductor property or an insulator property. For example, Eg-AlN may be 6.2 eV, and Eg-Si may be 1.1 eV, that is, the band gap of Si is relatively small. Therefore, when a temperature rises, an electron is easily transmitted to a conduction band of Si, so that Si has conductivity. However, for AlN, the band gap is relatively large, and compared with Si, even at a relatively high temperature, it is still a bad conductor of electricity. Therefore, in a semiconductor device, when Si is used as a substrate material, the electron is controlled to migrate to Si, so that conductivity of Si can be effectively controlled.

X: electronic affinity. It is energy required for an electron to move from the bottom of the conduction band to the vacuum level. For example, in FIG. 10a, XAlN indicates electronic affinity of AlN, and XSi indicates electronic affinity of Si. For example, XAlN may be 1.15 eV, and XSi may be 4.05 eV.

Compared with FIG. 10a and FIG. 10b, when the nucleation layer 31 includes AlN exhibiting an n-type conductive type, as shown in FIG. 10b, the AlN layer is subject to a relatively large tension stress and forms a relatively strong polarization effect, and thus an energy band is bent. A Fermi level of AlN of the donor is closer to the bottom of the conduction band than a Fermi level of Si.

As shown in FIG. 10b, when two different semiconductors (AlN and Si of the n-type conductive type) are in close contact to form a heterojunction, to balance the system, electrons are definitely transferred until the Fermi levels at everywhere in the system are completely the same. That is, electrons in the n-type AlN of the donor are transferred towards Si, the transfer of the electrons causes an energy band (including the vacuum level E$_0$, the bottom of the conduction band E$_C$, and the top of the valence band E$_V$, for example, the vacuum level E$_0$ in FIG. 10c and the bottom of the conduction band E$_C$ and the top of the valence band E$_V$ in FIG. 10b and FIG. 10c) near an interface to bend. Thus, a local conduction band space is below the Fermi level E$_F$, and the electrons automatically move to the region and gather. In this way, an energy band structure between the n-type AlN and Si enables the n-type AlN and Si to form, at the interface, an N-type parasitic channel of an inversion layer shown in FIG. 10c. Generally, the N-type parasitic channel of the inversion layer of this type has a relatively high conductivity capability, thereby increasing a radio frequency loss of the radio frequency semiconductor device and increasing power consumption of the radio frequency semiconductor device.

To overcome occurrence of the N-type parasitic channel of the inversion layer shown in FIG. 10c, as shown in FIG. 11, an embodiment of this application provides another radio frequency semiconductor device. FIG. 11 is a schematic diagram of a structure of the radio frequency semiconductor device 101. Similarities between the radio frequency semiconductor device 101 and the radio frequency semiconductor device 101 shown in FIG. 7 lie in that the radio frequency semiconductor device 101 also contains a substrate 1, a diffusion barrier layer 2, a nucleation layer 31, a channel layer 32, a barrier layer 33, and an electrode. Different from the radio frequency semiconductor device 101 shown in FIG. 7, in the structure shown in FIG. 11, the nucleation layer 31 contains a P-type impurity.

The P-type impurity may contain at least one of group II elements. For example, one or a combination of at least two of beryllium (Be), magnesium (Mg), calcium (Ca), strontium (Sr), and barium (Ba) in group IIA may be used.

For another example, one or a combination of at least two of zinc (Zn), mercury (Hg), and cadmium (Cd) in group IIB may be used.

For still another example, a combination of at least two of beryllium (Be), magnesium (Mg), calcium (Ca), strontium (Sr), barium (Ba), zinc (Zn), mercury (Hg), and cadmium (Cd) may be used.

For still another example, the P-type impurity may alternatively contain at least one element in IVA. For example, at least one of carbon (C) and silicon (Si) may be selected.

In addition, the P-type impurity may alternatively include a combination of at least two of different elements shown above. For example, magnesium (Mg) and carbon (C) may be included. For another example, zinc (Zn) and silicon (Si) may be included.

In the radio frequency semiconductor device 101 shown in FIG. 11, a thickness size range of the diffusion barrier layer 2 along a stacking direction may be less than 1 nm. Therefore, the diffusion barrier layer 2 may prevent group IIIA ions and/or group IIIA atoms of the nucleation layer 31, the channel layer 32, and the barrier layer 33 from being diffused to the substrate 1. However, because the diffusion barrier layer 2 is relatively thin, the diffusion barrier layer 2 cannot constrain an electron, that is, cannot prevent an electron in the nucleation layer 31 from migrating to the substrate 1. In this case, it may be considered that a heterojunction is formed between the nucleation layer 31 and the substrate 1.

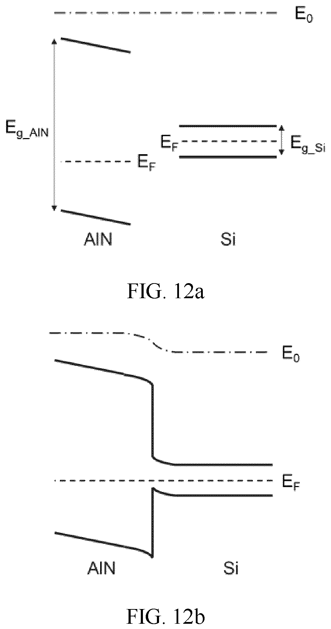

FIG. 12a is an energy band diagram of each of AlN exhibiting a P-type conductivity type and Si, and FIG. 12b is an energy band diagram of a heterojunction formed by AlN of the P-type conductivity type and Si. The physical significance represented by each quantity in the energy band diagram has been described above, and is not repeated herein.

Referring to FIG. 12a, when AlN exhibits the P-type conductive type, a Fermi level of AlN of an acceptor is closer to the top of the valence band than a Fermi level of Si. Similarly, when AlN of the P-type conductive type and Si are in close contact to form a heterojunction, after energy bands are aligned, the Fermi level $E_F$ is in a band gap, so that there is no region in which electrons can automatically gather. In this way, by comparing FIG. 12b with FIG. 10c, it can be seen that when the nucleation layer 31 exhibits a P type, formation of a parasitic channel of the inversion layer is effectively suppressed, radio frequency power consumption of the radio frequency semiconductor device is reduced, and operation performance of the radio frequency semiconductor device is improved.

Still referring to FIG. 12a, because $E_F$ of the heterojunction formed by AlN and Si is in the band gap, both an N-type parasitic channel and a P-type parasitic channel are effectively suppressed.

Referring to FIG. 11 again, not only the radio frequency semiconductor device 101 provided in this embodiment of this application includes the diffusion barrier layer 2 formed between the nucleation layer 31 and the substrate 1, but also the nucleation layer 31 has a P-type impurity. In this design, the diffusion barrier layer 2 can suppress diffusion of group IIIA (for example, aluminum and gallium) to the substrate 1, and suppress formation of the P-type parasitic channel in the substrate 1. The diffusion barrier layer 2 can further alleviate a lattice mismatch between the nucleation layer 31 and the substrate 1. In addition, the P-type impurity formed in the nucleation layer 31 can suppress formation of the N-type parasitic channel of the inversion layer on the surface layer of the substrate 1. In conclusion, when the radio frequency semiconductor device 101 contains the diffusion barrier layer 2 and the nucleation layer 31 containing the P-type impurity, not only formation of the P-type parasitic channel in the substrate 1 is suppressed, but also formation of the N-type parasitic channel in the substrate 1 is suppressed, thereby effectively suppressing the conductive capability of the substrate 1, reducing a parasitic loss of the substrate 1, and improving performance of the radio frequency semiconductor device 101.

In some embodiments, even if a small quantity of electrons in the nucleation layer 31 are migrated to the substrate 1 to form a P parasitic channel with relatively weak conductivity, by forming the P-type impurity in the nucleation layer 31, conductivity of the substrate 1 is also very weak; and correspondingly, the conductive capability of the substrate 1 is reduced, and radio frequency power consumption of the substrate 1 is reduced.

In some selectable implementation structures, a concentration p of the P-type impurity in the nucleation layer 31 in FIG. 11 may be $1\times10^{15}$ cm$^3$≤ρ≤$1\times10^{20}$ cm$^{-3}$. For example, when Mg is selected for the P-type impurity, a concentration p of Mg may be: $1\times10^{15}$ cm$^3$≤ρ≤$1\times10^{20}$ cm$^{-3}$. For example, the concentration of Mg may be selected to be $1\times10^{18}$ cm$^{-3}$. For another example, when a mixture of C and Si is selected for the P-type impurity, concentrations of C and Si may be both $1\times10^{18}$ cm$^{-3}$.

In addition, in some implementable structures, a range of a thickness d of the nucleation layer 31 containing the P-type impurity is: 1 nm≤d≤300 nm. For example, d=150 nm, d=200 nm, d=250 nm, or d=300 nm may be selected. The thickness d of the nucleation layer 31 herein is the thickness of the nucleation layer 31 along the stacking direction of these film layer structures, that is, a thickness size along the L direction shown in FIG. 9.

According to the radio frequency semiconductor device 101 provided in this embodiment of this application, as shown in FIG. 11, a radio frequency loss of the substrate 1 or a radio frequency loss of another layer structure formed through epitaxy may be measured by machining a coplanar waveguide (coplanar waveguide, CPW) line on a surface of an epitaxial layer. For example, the radio frequency loss may be measured by machining a coplanar waveguide (coplanar waveguide, CPW) line on a surface of the barrier layer 33 in FIG. 11. In some embodiments, a radio frequency loss of an entire radio frequency device of an epitaxial substrate of gallium nitride on silicon may be less than 0.25 dB/mm in a frequency band below 40 GHz through CPW measurement. Compared with an existing radio frequency loss greater than 0.4 dB/mm, the radio frequency loss of the radio frequency semiconductor device provided in this embodiment of this application is obviously reduced.

A full width at half maximum of a rocking curve of the nucleation layer 31 containing the P-type impurity may be measured by using an X-ray diffraction (X-ray diffraction, XRD) meter. The full width at half maximum of the rocking curve refers to a full width at half maximum of a rocking curve measured under a diffraction peak in an omega scanning mode on a crystal surface 0002 of an AlN nucleation layer. In this embodiment, the full width at half maximum of the rocking curve of the crystal surface 0002 of the nucleation layer 31 containing the P-type impurity (for example, AlN in the nucleation layer 31 is a hexagonal crystal system, and the crystal surface 0002 is a crystal surface parallel to a surface of a stacking layer) is less than 800 arc seconds.

Surface roughness of the nucleation layer 31 containing the P-type impurity may be measured by using atomic force microscopy (atomic force microscopy, AFM). The surface roughness of the nucleation layer 31 provided in this embodiment may be less than 1 nm.

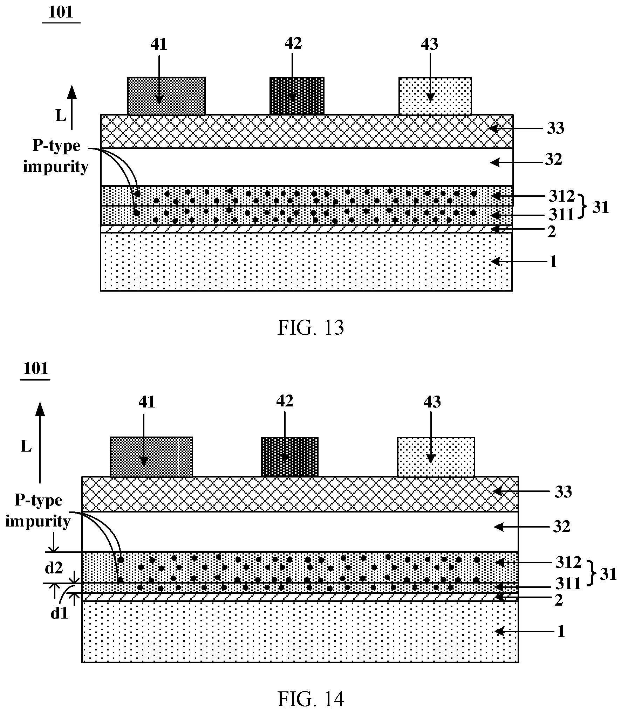

To further suppress the radio frequency loss of the radio frequency semiconductor device, as shown in FIG. 13, an embodiment of this application further provides a structure of a radio frequency semiconductor device 101, and FIG. 13 is a diagram of a structure of the radio frequency semiconductor device 101. A difference between the structure shown in FIG. 13 and the structure shown in FIG. 11 lies in that the nucleation layer 31 includes a first nucleation layer 311 and a second nucleation layer 312 that are stacked along a first direction L. That is, the first nucleation layer 311 may be stacked on the diffusion barrier layer 2, and the second nucleation layer 312 may be stacked on the first nucleation layer 311. In addition, a P-type impurity is formed in each of the first nucleation layer 311 and the second nucleation layer 312.

FIG. 13 shows an example that the nucleation layer 31 includes a two-layer structure in which the first nucleation layer 311 and the second nucleation layer 312 are stacked. In some other implementable structures, based on the structure shown in FIG. 13, more nucleation layers may be included, for example, three layers, four layers, or even more layers.

In the structure exemplified in FIG. 13, for a material selected for the P-type impurity in the first nucleation layer 311 and the second nucleation layer 312, refer to the foregoing description. A specific material of the P-type impurity is not described herein again.

In some implementable structures, as shown in FIG. 13, a P-type impurity element in the first nucleation layer 311 may be different from a P-type impurity element in the second nucleation layer 312.

For the P-type impurity element in the first nucleation layer 311 being different from the P-type impurity element in the second nucleation layer 312, refer to the following explanations:

For example, when either of the first nucleation layer 311 and the second nucleation layer 312 includes only one P-type impurity element, the P-type impurity elements of the two nucleation layers are different P-type impurity elements, that is, the P-type impurity element in the first nucleation layer 311 is considered different from the P-type impurity element in the second nucleation layer 312. For example, the P-type impurity element in the first nucleation layer 311 is magnesium (Mg), and the P-type impurity element in the second nucleation layer 312 is carbon (C).

For another example, when both the first nucleation layer 311 and the second nucleation layer 312 include at least two P-type impurity elements, the P-type impurity elements in the first nucleation layer 311 are completely different from the P-type impurity elements in the second nucleation layer 312, that is, the P-type impurity elements in the first nucleation layer 311 are considered different from the P-type impurity elements in the second nucleation layer 312. For example, if the P-type impurity elements in the first nucleation layer 311 are magnesium (Mg) and carbon (C), the P-type impurity elements in the second nucleation layer 312 are calcium (Ca) and silicon (Si) that are different from magnesium (Mg) and carbon (C).

For another example, when both the first nucleation layer 311 and the second nucleation layer 312 include at least two P-type impurity elements, the P-type impurity elements in the first nucleation layer 311 are partially the same as the P-type impurity elements in the second nucleation layer 312, and are partially different from the P-type impurity elements in the second nucleation layer 312. The P-type impurity elements in the first nucleation layer 311 are also considered different from the P-type impurity elements in the second nucleation layer 312. For example, when the P-type impurity elements in the first nucleation layer 311 are magnesium (Mg) and carbon (C), and the P-type impurity elements in the second nucleation layer 312 are magnesium (Mg) and silicon (Si), that is, the P-type impurity elements in the first nucleation layer 311 are different from the P-type impurity elements in the second nucleation layer 312.

FIG. 14 is a diagram of a structure of another radio frequency semiconductor device 101 according to an embodiment of this application. As shown in FIG. 14, in the radio frequency semiconductor device 101, a nucleation layer 31 includes a first nucleation layer 311 and a second nucleation layer 312 that are stacked, and along a stacking direction L shown in FIG. 14, a thickness d1 of the first nucleation layer 311 is not equal to a thickness d2 of the second nucleation layer 312. For example, the thickness d1 of the first nucleation layer 311 may be less than the thickness d2 of the second nucleation layer 312, or the thickness d1 of the first nucleation layer 311 may be greater than the thickness d2 of the second nucleation layer 312.

In some examples, the thickness d1 of the first nucleation layer 311 may be less than or equal to 100 nm and greater than or equal to 1 nm, for example, may be 50 nm.

In some other examples, the thickness d2 of the second nucleation layer 312 may be less than or equal to 250 nm and greater than or equal to 100 nm, for example, may be 150 nm.

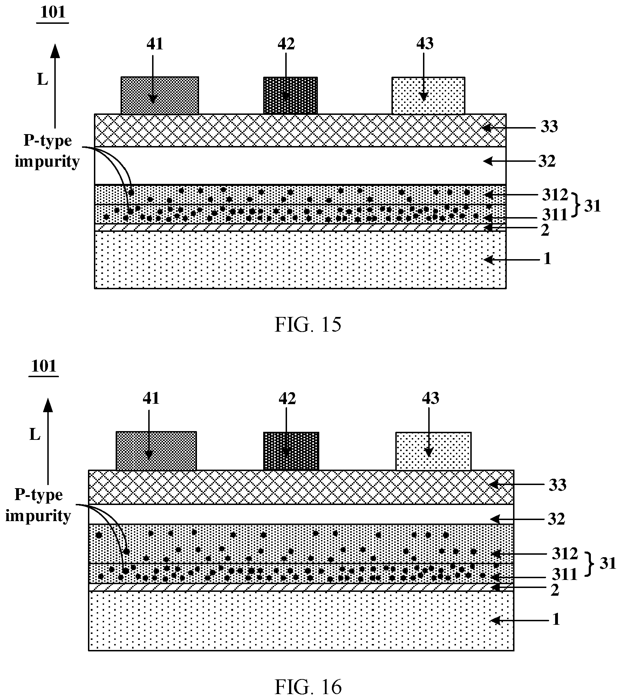

When the nucleation layer 31 includes a multi-layer structure, to prevent P-type impurities from forming a parasitic channel in the nucleation layer 31, concentrations of the P-type impurities in the multi-layer nucleation layer 31 may be made different. For example, as shown in FIG. 15, FIG. 15 is still a diagram of a structure of still another radio frequency semiconductor device 101 according to an embodiment of this application, a concentration $\rho_1$ of a P-type impurity in a first nucleation layer 311 in FIG. 15 is greater than a concentration $\rho_2$ of a P-type impurity in a second nucleation layer 312, and the first nucleation layer 311 is disposed closer to a diffusion barrier layer 2 than the second nucleation layer 312. Herein, that the concentration of the P-type impurity in the first nucleation layer 311 is greater than the concentration of the P-type impurity in the second nucleation layer 312 may be understood as follows: The concentration of the P-type impurity in the first nucleation layer 311 differs by at least one order of magnitude from the concentration of the P-type impurity in the second nucleation layer 312, that is, this may be $\rho_1/\rho_2 > 10$. For example, if the concentration $\rho_1$ of the P-type impurity in the first nucleation layer 311 is $10^{19}$ cm$^{-3}$, the concentration $\rho_2$ of the P-type impurity in the second nucleation layer 312 may be $10^{17}$ cm$^{-3}$.

In FIG. 15, black dots are used to represent P-type impurities. A larger quantity of P-type impurities indicates a larger concentration of P-type impurities, and a smaller quantity of P-type impurities indicates a smaller concentration of P-type impurities.

In some examples, the concentration $\rho_1$ of the P-type impurity in the first nucleation layer 311 may be $1\times10^{17}$ cm$^{-3}$$\leq\rho\leq1\times10^{20}$ cm$^{-3}$. For example, the concentration $\rho_1$ of the P-type impurity may be $1\times10^{19}$ cm$^{-3}$.

In some other examples, the concentration $\rho_2$ of the P-type impurity in the second nucleation layer 312 may be $1\times10^{15}$ cm$^3$$\leq\rho\leq1\times10^{18}$ cm$^{-3}$. For example, the concentration $\rho_2$ of the P-type impurity may be $1\times10^{17}$ cm$^{-3}$.

In such a design, the first nucleation layer 311 with a relatively high concentration of P-type impurities can effectively suppress formation of an N-type parasitic channel of an inversion layer on a surface layer of a substrate 1, thereby reducing a conductivity capability of the substrate 1, so as to reduce radio frequency power consumption of the radio frequency semiconductor device. In addition, the second nucleation layer 312 with a relatively low concentration of P-type impurities can avoid parasitic conductivity, in the nucleation layer, caused by an excessively high concentration of P-type impurities. In some implementable structures, a radio frequency conduction loss of the radio frequency semiconductor device shown in FIG. 15 may be less than 0.20 dB/mm in a frequency band below 40 GHz. In this way, the radio frequency loss of the radio frequency device can be further obviously reduced.

In some embodiments, if more stacked nucleation layers are disposed on the basis of FIG. 15, concentrations of P-type impurities in the nucleation layers gradually decrease along a direction away from the substrate 1. For example, the concentrations of the P-type impurities in the nucleation layers may decrease to a value close to zero in a topmost nucleation layer away from the substrate 1.

In some implementable structures, a change in the concentrations of the P-type impurities in the plurality of nucleation layers may be combined with a change in thicknesses of the plurality of nucleation layers, to form some other radio frequency semiconductor devices. For example, as shown in FIG. 16, FIG. 16 is a diagram of a structure of another radio frequency semiconductor device 101 according to an embodiment of this application.

In this embodiment, along a direction away from a substrate 1, thicknesses of a plurality of nucleation layers gradually increase, and concentrations of P-type impurities in the plurality of nucleation layers gradually decrease. For example, in FIG. 16, a thickness of a first nucleation layer 311 close to the substrate 1 is less than a thickness of a second nucleation layer 312 away from the substrate 1, and a concentration of a P-type impurity in the first nucleation layer 311 is greater than a concentration of a P-type impurity in the second nucleation layer 312.

When the embodiment shown in FIG. 16 is prepared, the first nucleation layer 311 close to the substrate 1 has a large lattice mismatch with the substrate 1, generally grows at a low temperature condition, and has poor crystal quality. The thickness of the first nucleation layer 311 is kept as thin as possible. When the second nucleation layer 312 is grown, the second nucleation layer 312 generally grows at a high temperature condition, and crystal quality gradually improves as a growth thickness increases. Therefore, the thickness of the second nucleation layer 312 may be greater than the thickness of the first nucleation layer 311. In addition, compared with the second nucleation layer 312, the first nucleation layer 311 is doped with a higher concentration, so that the first nucleation layer 311 has a larger conductive capability compared with the second nucleation layer 312. Further, when it is ensured that formation of an N-type parasitic channel can be suppressed in the substrate 1, the thickness of the first nucleation layer 311 is kept as thin as possible, and the conductive capability of the first nucleation layer 311 is reduced.

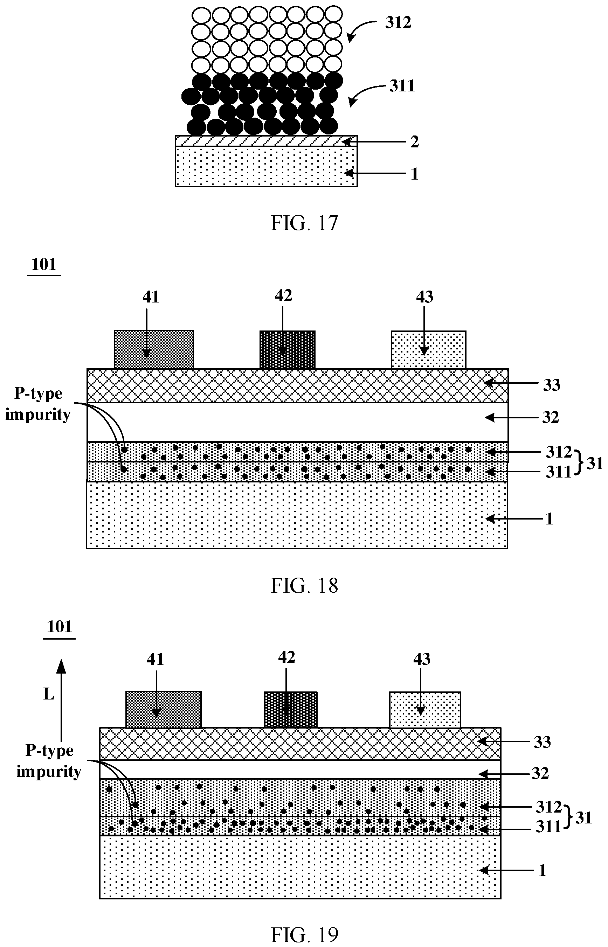

FIG. 17 is a diagram of a structure of yet another radio frequency semiconductor device according to an embodiment of this application. FIG. 17 shows only a substrate 1, a diffusion barrier layer 2, a first nucleation layer 311, and a second nucleation layer 312 of the radio frequency semiconductor device, and does not show another film layer structure.

FIG. 17 is crystal arrangement model diagrams of the first nucleation layer 311 and the second nucleation layer 312. A black circle indicates a crystal arrangement in the first nucleation layer 311, and a white circle indicates a crystal arrangement in the second nucleation layer 312. The two crystal model diagrams are merely examples for description, and do not constitute a specific limitation on the crystal arrangements of the first nucleation layer 311 and the second nucleation layer 312 in this application.

It can be seen from the example crystal arrangements of the first nucleation layer 311 and the second nucleation layer 312 in FIG. 17 that, in this embodiment, a dislocation density of the second nucleation layer 312 disposed away from the substrate 1 is less than a dislocation density of the first nucleation layer 311 disposed close to the substrate 1, that is, the dislocation densities of the nucleation layers may gradually decrease along a direction away from the substrate 1.

In an implementable process, when a plurality of nucleation layers are prepared, a growth temperature may be controlled, so that dislocation densities of the nucleation layers can gradually decrease along the direction away from the substrate 1. For example, in FIG. 17, when the first nucleation layer 311 is formed, the growth temperature may be controlled to be 700°C, and the growth temperature of the second nucleation layer 312 may be controlled to be 1100°C. In this way, crystal arrangements in the nucleation layers can gradually become neat along the direction away from the substrate 1, thereby helping form, on the nucleation layer, a channel layer 32, a barrier layer 33, or another film layer structure with neat crystal arrangements. In addition, this helps prevent the first nucleation layer 311 from generating an excessively large tension stress, thereby reducing a risk of crack generation.

With reference to FIG. 13 to FIG. 17 together, in these implementable structures, not only the diffusion barrier layer 2 is formed in the substrate 1 and the nucleation layer 31, but also at least two stacked nucleation layer structures are included. In other words, on the basis of preventing, by using the diffusion barrier layer 2, diffusion of a group IIIA element in the nucleation layer 31 towards the substrate 1, and suppressing formation of a P-type parasitic channel in the substrate 1, a nucleation layer that is in a plurality of nucleation layers and that is close to a bottom layer of the substrate 1 may be further used to suppress formation of an N-type parasitic channel in the substrate 1. In addition, the plurality of nucleation layers also lay foundations for high-quality formation of another film layer structure in a subsequent process. That is, the crystal arrangements of the channel layer 32 and the barrier layer 33 can be neater, and electron mobility is higher. In addition, a P-type parasitic channel is not to be introduced into a layer structure of the nucleation layer, so that performance of the radio frequency semiconductor device is better.

In addition to the foregoing radio frequency semiconductor devices of different structures, an embodiment of this application further provides several different radio frequency semiconductor devices, to suppress formation of a parasitic channel in the substrate 1, as shown below.

FIG. 18 is a diagram of a structure of a radio frequency semiconductor device according to an embodiment of this application. A difference between the radio frequency semiconductor device 101 of this structure and the foregoing radio frequency semiconductor device lies in that the radio frequency semiconductor device 101 may not include the diffusion barrier layer 2, but may form the nucleation layer 31 on the substrate 1.

In addition, the nucleation layer 31 in FIG. 18 includes at least two stacked layers. For example, the nucleation layer 31 includes a first nucleation layer 311 and a second nucleation layer 312 that are stacked.

In the radio frequency semiconductor device 101 shown in FIG. 18, it is considered that the nucleation layer 31 containing the first nucleation layer 311 and the second nucleation layer 312 may directly cover the substrate 1.

In addition, more nucleation layers, for example, three layers, four layers, or even more layers, may be stacked on the basis of FIG. 18.

When the nucleation layer shown in FIG. 18 includes at least two layers, for a selectable material, a concentration magnitude, a dislocation density, a growth temperature, and the like of the plurality of nucleation layers, refer to descriptions of the first nucleation layer 311 and the second nucleation layer 312 in the structures shown in FIG. 13 to FIG. 17.

For example, FIG. 19 is a diagram of a structure of a radio frequency semiconductor device containing a first nucleation layer 311 and a second nucleation layer 312 according to an embodiment of this application. In this embodiment, a concentration $\rho_1$ of a P-type impurity in the first nucleation layer 311 is greater than a concentration $\rho_2$ of the P-type impurity in the second nucleation layer 312.

Still referring to FIG. 19, the first nucleation layer 311 and a substrate 1 adjacent to the first nucleation layer 311 form a heterojunction because of different energy bands. However, because the first nucleation layer 311 contains a relatively high concentration of P-type impurities, formation of an N-type parasitic channel of an inversion layer on a surface layer of the substrate 1 can be effectively suppressed, thereby reducing a conductivity capability of the substrate 1 and reducing radio frequency power consumption of the radio frequency semiconductor device.

In addition, the second nucleation layer 312 with a relatively low concentration of P-type impurities can also avoid parasitic conductivity, in the nucleation layer, caused by an excessively high concentration of P-type impurities.

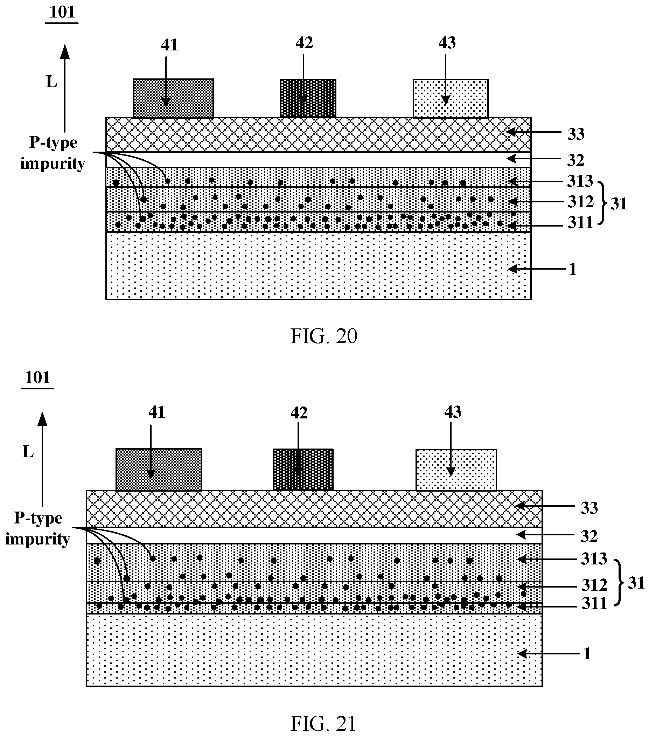

For another example, FIG. 20 is a diagram of a structure of another radio frequency semiconductor device containing a nucleation layer according to an embodiment of this application. A difference between the structure shown in FIG. 20 and the structure shown in FIG. 19 lies in that in FIG. 20, not only the first nucleation layer 311 and the second nucleation layer 312 that are stacked, but also a third nucleation layer 313 stacked on the second nucleation layer 312 are included, and the third nucleation layer 313 also contains a P-type impurity.

In addition, along a direction L away from the substrate 1, concentrations of P-type impurities in the first nucleation layer 311, the second nucleation layer 312, and the third nucleation layer 313 gradually decrease.

For still another example, FIG. 21 is a diagram of a structure of still another radio frequency semiconductor device containing a nucleation layer according to an embodiment of this application. The structure shown in FIG. 21 is the same as the structure shown in FIG. 20, and also contains the first nucleation layer 311, the second nucleation layer 312, and the third nucleation layer 313 that are stacked, and along a direction L away from the substrate 1, concentrations of P-type impurities in the first nucleation layer 311, the second nucleation layer 312, and the third nucleation layer 313 gradually decrease. In the structure shown in FIG. 20, thicknesses of the first nucleation layer 311, the second nucleation layer 312, and the third nucleation layer 313 are basically the same. However, in the embodiment shown in FIG. 21, along the direction L away from the substrate 1, the thicknesses of the first nucleation layer 311, the second nucleation layer 312, and the third nucleation layer 313 gradually increase.

The foregoing describes a plurality of radio frequency semiconductor devices with different structures provided in the embodiments of this application. The following describes some preparation methods for a radio frequency semiconductor device. For details, refer to the following description.

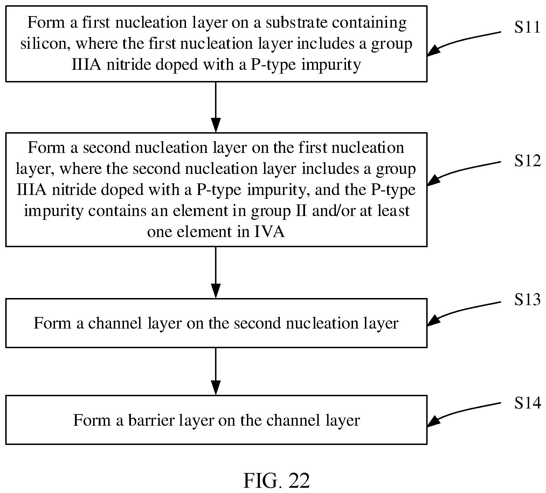

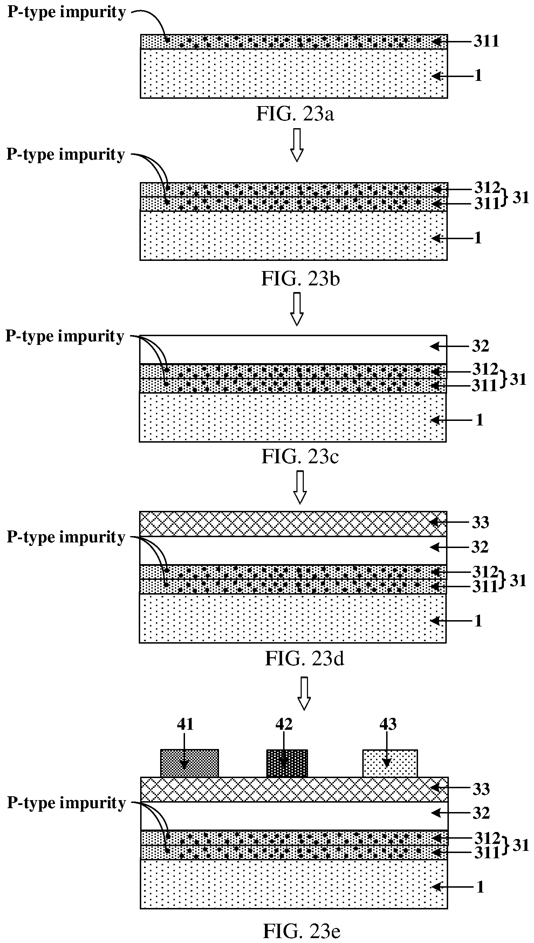

FIG. 22 is a process flow diagram of a preparation method for the radio frequency semiconductor device, and FIG. 23a to FIG. 23d are sectional views after each step of the process flow for manufacturing the radio frequency semiconductor device is completed.

As shown in step S11 in FIG. 22 and FIG. 23a, FIG. 23a is a diagram of a structure after step S11 in FIG. 22 is performed.

As shown in step S11 in FIG. 22 and FIG. 23a, a first nucleation layer 311 is formed on a substrate 1 containing silicon, where the first nucleation layer 311 includes a group IIIA nitride doped with a P-type impurity.

When the first nucleation layer 311 is prepared, an epitaxial growth technology may be used. For example, the epitaxial growth technology includes but is not limited to metal-organic vapor phase epitaxy MOVPE, molecular beam epitaxy MBE, or another single-crystal epitaxial growth technology.

In addition, when the first nucleation layer 311 is prepared, a corresponding P-type impurity doping precursor may include but is not limited to diethyl beryllium (DEBe), bis-cyclopentadienyl magnesium ($Cp_2Mg$), dimethyl zinc (DMZn), calcium diisopropyl dithiocarbamate $Ca(DPTC)_2$, methane ($CH_4$), ethylene ($C_2H_4$), silane ($SiH_4$), or disilane ($Si_2H_6$). For example, bis-cyclopentadienyl magnesium ($Cp_2Mg$) may be selected as a doping precursor during epitaxial growth of the first nucleation layer 311 of AlN.

In addition, a doping concentration of the P-type impurity may be controlled by controlling a carrier flow of the doping precursor. For example, the doping concentration of the P-type impurity may be controlled by controlling a carrier gas $NH_3$.

In some implementable process flows, Mg may also be selected as the P-type impurity, and a concentration p of Mg may be: $1 \times 10^{17}$ $cm^{-3} \leq \rho \leq 1 \times 10^{23}$ $cm^{-3}$. For example, the concentration p of Mg may be $1 \times 10^{22}$ $cm^{-3}$.

In addition, a growth temperature of the p-type doped first nucleation layer 311 is between 600°C and 1100°C, and may include 600°C and 1100°C. For example, about 1000°C may be selected.

As shown in step S11 in FIG. 22 and FIG. 23b, FIG. 23b is a diagram of a structure after step S12 in FIG. 22 is performed.

As shown in step S12 in FIG. 22 and FIG. 23b, a second nucleation layer 312 is formed on the first nucleation layer 311, where the second nucleation layer 312 includes a group IIIA nitride doped with a P-type impurity.

The P-type impurity herein may contain an element in group II and/or at least one element in IVA.

Similar to the foregoing formation of the first nucleation layer 311, when the second nucleation layer 312 is prepared, an epitaxial growth technology may be used. For example, the epitaxial growth technology includes but is not limited to metal-organic vapor phase epitaxy MOVPE, molecular beam epitaxy MBE, or another single-crystal epitaxial growth technology.

In addition, the first nucleation layer 311 and the second nucleation layer 312 may be prepared in a same device.

In step S12 in FIG. 22, a corresponding P-type impurity doping precursor may include but is not limited to diethyl beryllium (DEBe), bis-cyclopentadienyl magnesium ($Cp_2Mg$), dimethyl zinc (DMZn), calcium diisopropyl dithiocarbamate $Ca(DPTC)_2$, methane ($CH_4$), ethylene ($C_2H_4$), silane ($SiH_4$), or disilane ($Si_2H_6$).

The P-type impurity doping precursor in step S12 in FIG. 22 may be the same as or different from the P-type impurity doping precursor in step S11 in FIG. 22.

In some implementable process flows, mixed doping of C and Si may be selected, and a concentration p of C and Si may be: $1 \times 10^{15}$ $cm^{-3} \leq \rho \leq 1 \times 10^{18}$ $cm^{-3}$. For example, the concentration p of C and Si may be $1 \times 10^{17}$ $cm^{-3}$.

In addition, a growth temperature of the p-type doped first nucleation layer 311 is between 600°C and 1100°C, and may include 600°C and 1100°C. For example, about 1100°C may be selected.

As shown in step S13 in FIG. 22 and FIG. 23c, FIG. 23c is a diagram of a structure after step S13 in FIG. 22 is performed.

As shown in step S13 in FIG. 22 and FIG. 23c, a channel layer 32 is formed on the second nucleation layer 312.

The channel layer 32 may also use an epitaxial growth technology, for example, the foregoing metal-organic vapor phase epitaxy MOVPE and molecular beam epitaxy MBE.

As shown in step S14 in FIG. 22 and FIG. 23d, FIG. 23d is a diagram of a structure after step S14 in FIG. 22 is performed.

As shown in step S14 in FIG. 22 and FIG. 23d, a barrier layer 33 is formed on the channel layer 32.

In some process flows, before the channel layer 32 is formed, a stress buffer layer may be formed on the nucleation layer 31 including the first nucleation layer 311 and the second nucleation layer 312, and then the channel layer 32 is formed on the stress buffer layer.

In some other process flows, before the barrier layer 33 is formed, an isolation layer may be formed on the channel layer 32, and then the barrier layer 33 is formed on the isolation layer.

In still some other process flows, a cap layer may be formed on the barrier layer 33 after the barrier layer 33 is formed, so as to form a source (Source) 41, a gate (Gate) 42, and a drain (Drain) 43 shown in FIG. 23e on the cap layer.

In the radio frequency semiconductor device prepared by using FIG. 22 and FIG. 23a to FIG. 23e, the nucleation layer 31 includes the first nucleation layer 311 and the second nucleation layer 312 that are stacked, and the P-type impurity is doped in both the first nucleation layer 311 and the second nucleation layer 312 by using a doping process, so that formation of an N-type parasitic channel is suppressed on a surface layer of the substrate 1.

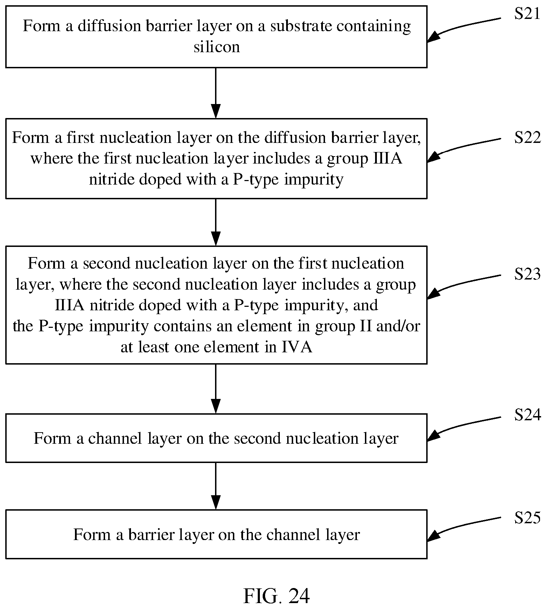

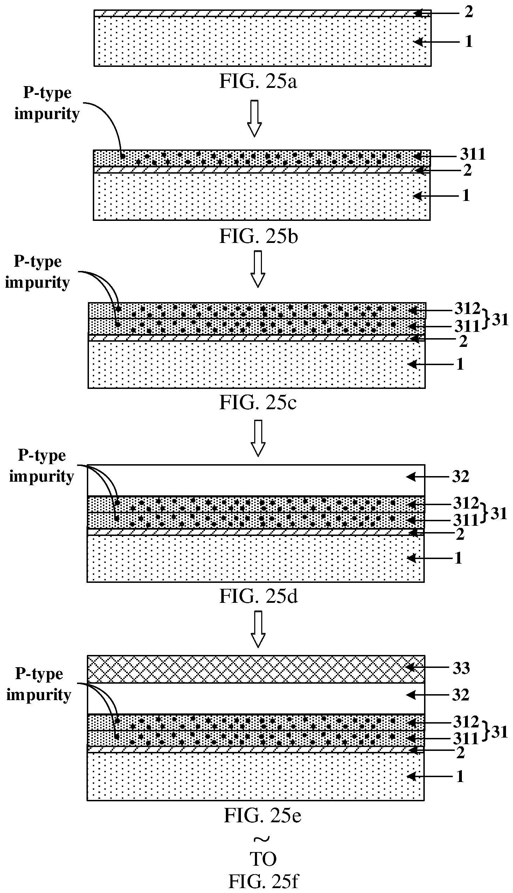

An embodiment of this application further provides another preparation method for a radio frequency semiconductor device, as shown in FIG. 24 and FIG. 25a to FIG. 25e. FIG. 24 is a process flow diagram of a preparation method for the radio frequency semiconductor device, and FIG. 25a to FIG. 25e are sectional views after each step of the process flow for manufacturing the radio frequency semiconductor device is completed.

As shown in step S21 in FIG. 24 and FIG. 25a, FIG. 25a is a diagram of a structure after step S21 in FIG. 24 is performed.

As shown in step S21 in FIG. 24 and FIG. 25a, a diffusion barrier layer 2 is formed on a substrate 1 containing silicon.

When the diffusion barrier layer 2 is formed, an ammonia gas may be pre-introduced for nitrification preprocessing, to form a silicon nitride thin film on the substrate 1 containing silicon as the diffusion barrier layer 2. For another example, an aluminum oxide thin film may be formed on the substrate 1 containing silicon by using an epitaxial growth technology as the diffusion barrier layer 2.

As shown in step S22 in FIG. 24 and FIG. 25b, a first nucleation layer 311 is formed on the diffusion barrier layer 2, where the first nucleation layer 311 includes a group IIIA nitride doped with a P-type impurity.

As shown in step S23 in FIG. 24 and FIG. 25c, a second nucleation layer 312 is formed on the first nucleation layer 311, where the second nucleation layer 312 includes a group IIIA nitride doped with a P-type impurity.

The P-type impurity herein may contain an element in group II and/or at least one element in IVA.

As shown in step S24 in FIG. 24 and FIG. 25d, a channel layer 32 is formed on the second nucleation layer 312.

As shown in step S25 in FIG. 24 and FIG. 25e, a barrier layer 33 is formed on the channel layer 32.

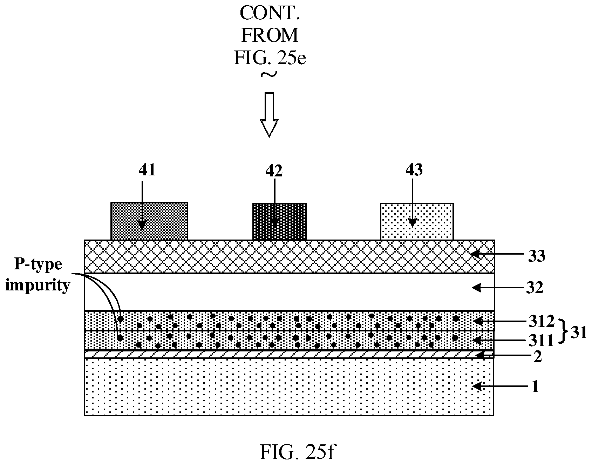

As shown in FIG. 25f, a source (Source) 41, a gate (Gate) 42, and a drain (Drain) 43 are on the barrier layer 33.

For preparation methods for the first nucleation layer 311, the second nucleation layer 312, the channel layer 32, and the barrier layer 33 in FIG. 24, refer to the preparation methods for corresponding film layer structures in FIG. 25a to FIG. 25f.

In the radio frequency semiconductor device prepared by using FIG. 24 and FIG. 25a to FIG. 25f, the nucleation layer 31 includes the first nucleation layer 311 and the second nucleation layer 312 that are stacked, and the P-type impurity is doped in both the first nucleation layer 311 and the second nucleation layer 312 by using a doping process. In addition, the diffusion barrier layer 2 is formed between the substrate 1 and the nucleation layer 31. In this way, not only formation of an N-type parasitic channel can be suppressed on a surface layer of the substrate 1, but also formation of a P-type parasitic channel can be suppressed on the surface layer of the substrate 1, so as to further reduce a radio frequency loss of the radio frequency semiconductor device.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A radio frequency semiconductor device, comprising:

   a substrate, containing silicon;
   a nucleation layer, formed on the substrate;
   a channel layer, formed on the nucleation layer; and
   a barrier layer, formed on the channel layer, wherein
   the nucleation layer, the channel layer, and the barrier layer all contain a group IIIA nitride;
   the nucleation layer comprises a first nucleation layer and a second nucleation layer that are stacked in a first direction, the first nucleation layer is formed on the substrate, and the second nucleation layer is formed on the first nucleation layer;
   both the first nucleation layer and the second nucleation layer contain a P-type impurity, and the P-type impurity contains at least one element in group II and/or IVA; and
   a concentration of the P-type impurity in the first nucleation layer is greater than a concentration of the P-type impurity in the second nucleation layer; and/or the P-type impurity in the first nucleation layer is different from the P-type impurity in the second nucleation layer.

2. The radio frequency semiconductor device according to claim 1, wherein along the first direction, a thickness of the first nucleation layer is less than a thickness of the second nucleation layer.

3. The radio frequency semiconductor device according to claim 2, wherein

   the thickness $d_1$ of the first nucleation layer is 1 nm$\leq d_1 \leq$100 nm; and
   the thickness $d_2$ of the second nucleation layer is 100 nm$\leq d_2 \leq$250 nm.

4. The radio frequency semiconductor device according to any one of claims 1 to 3, wherein a dislocation density of the second nucleation layer is less than a dislocation density of the first nucleation layer.

5. The radio frequency semiconductor device according to any one of claims 1 to 4, wherein both the P-type impurity in the first nucleation layer and the P-type impurity in the second nucleation layer contain at least two elements.

6. The radio frequency semiconductor device according to any one of claims 1 to 5, wherein both a full width at half maximum of a rocking curve of the first nucleation layer and a full width at half maximum of a rocking curve of the second nucleation layer are less than or equal to 800 arc seconds.

7. The radio frequency semiconductor device according to any one of claims 1 to 6, wherein

   the concentration of the P-type impurity in the first nucleation layer is $\rho_1$; and
   the concentration of the P-type impurity in the second nucleation layer is $\rho_2$, wherein

$$\rho_1/\rho_2 > 10.$$

8. The radio frequency semiconductor device according to claim 7, wherein

   $\rho_1$ is $1\times10^{17}$ cm$^{-3}\leq\rho_1\leq1\times10^{20}$ cm$^{-3}$; and
   $\rho_2$ is $1\times10^{15}$ cm$^{-3}\leq\rho_2\leq1\times10^{18}$ cm$^{-3}$.

9. The radio frequency semiconductor device according to any one of claims 1 to 8, wherein the P-type impurity comprises at least one of beryllium, magnesium, calcium, zinc, carbon, and silicon.

10. The radio frequency semiconductor device according to claim 9, wherein

    the P-type impurity in the first nucleation layer comprises magnesium; and
    the P-type impurity in the second nucleation layer comprises at least two of magnesium, carbon, and silicon.

11. The radio frequency semiconductor device according to any one of claims 1 to 9, wherein the group IIIA nitride in the first nucleation layer is the same as the group IIIA nitride in the second nucleation layer.

12. The radio frequency semiconductor device according to any one of claims 1 to 11, wherein the radio frequency semiconductor device further comprises a diffusion barrier layer; and
    along the first direction, the diffusion barrier layer is formed between the substrate and the first nucleation layer.

13. A preparation method for a radio frequency semiconductor device, wherein the preparation method comprises:

    forming a first nucleation layer on a substrate containing silicon, wherein the first nucleation layer comprises a group IIIA nitride doped with a P-type impurity; and
    forming a second nucleation layer on the first nucleation layer, wherein the second nucleation layer comprises a group IIIA nitride doped with a P-type impurity, wherein
    the P-type impurity contains at least one element in group II and/or IVA; and
    a concentration of the P-type impurity in the first nucleation layer is greater than a concentration of the P-type impurity in the second nucleation layer; and/or the P-type impurity in the first nucleation layer is different from the P-type impurity in the second nucleation layer.

14. The preparation method for a radio frequency semiconductor device according to claim 13, wherein a precursor for forming the first nucleation layer and/or the second nucleation layer comprises at least one of diethyl beryllium, bis-cyclopentadienyl magnesium, dimethyl zinc, calcium diisopropyl dithiocarbamate, methane, ethylene, silane, and disilane.

15. The preparation method for a radio frequency semiconductor device according to claim 13 or 14, wherein before the forming a first nucleation layer on a substrate containing silicon, the preparation method further comprises:
    forming a diffusion barrier layer on the substrate containing silicon, to form the first nucleation layer on the diffusion barrier layer.

16. A radio frequency semiconductor device, comprising:

> a substrate, containing silicon;
> a diffusion barrier layer, formed on the substrate;
> a nucleation layer, formed on the diffusion barrier layer;
> a channel layer, formed on the nucleation layer; and
> a barrier layer, formed on the channel layer, wherein
> the nucleation layer, the channel layer, and the barrier layer all contain a group IIIA nitride; and
> the nucleation layer further contains a P-type impurity, and the P-type impurity contains at least one element in group II and/or IVA.

17. The radio frequency semiconductor device according to claim 16, wherein a concentration p of the P-type impurity in the nucleation layer is: $1 \times 10^{15}$ cm$^{-3} \leq \rho \leq 1 \times 10^{20}$ cm$^{-3}$.

18. The radio frequency semiconductor device according to claim 16 or 17, wherein a thickness d of the nucleation layer is 1 nm$\leq$d$\leq$300 nm.

19. The radio frequency semiconductor device according to any one of claims 16 to 18, wherein
the P-type impurity in the nucleation layer comprises at least one of magnesium, carbon, and silicon.

20. An electronic device, comprising:

> a circuit board; and
> the radio frequency semiconductor device according to any one of claims 1 to 12, a radio frequency semiconductor device prepared according to the preparation method for a radio frequency semiconductor device according to any one of claims 13 to 15, or the radio frequency semiconductor device according to any one of claims 16 to 19, wherein
> the radio frequency semiconductor device is disposed on the circuit board.

| Source | Gate | Drain |
|--------|------|-------|

**AlGaN layer**

**GaN layer**

**Silicon substrate**

Parasitic
conductive
channel

FIG. 1

Base
station

Antenna

| Control unit |
|--------------|

Core
network

| Transmission
unit | Baseband
unit |

| RF | PA |
| RF | PA |
| RF | PA |

| Power supply
unit |

FIG. 2

13

12

111
11
110

FIG. 3

101
102
103
200

100

FIG. 4

**101**

| Source | | Gate | | Drain |
|---|---|---|---|---|

| AlGaN layer |
|---|
| GaN layer |
| AlN layer |
| Silicon substrate |

FIG. 5

FIG. 6

FIG. 7

41
42
43

FIG. 8

101

41          42          43

L

36
33
35
32
34
A          31
2
1

FIG. 9

FIG. 10a

FIG. 10b

$E_0$

N-type parasitic
channel of an
inversion layer

$E_F$

AlN                                         Si

FIG. 10c

**101**

41          42          43

L

P-type
impurity

d

33
32
31
2
1

FIG. 11

$E_0$

$E_{g\_AIN}$

$E_F$

$E_F$

$E_{g\_Si}$

AIN                    Si

FIG. 12a

$E_0$

$E_F$

AIN                    Si

FIG. 12b

**101**

41        42        43

L

P-type
impurity

33

32

312 ⎫
        ⎬ 31
311 ⎭

2

1

FIG. 13

**101**

41        42        43

L

P-type
impurity

d2

d1

33

32

312 ⎫
        ⎬ 31
311 ⎭

2

1

FIG. 14

**101**

L

41    42    43

P-type
impurity

33
32
312 } 31
311
2
1

FIG. 15

**101**

L

41    42    43

P-type
impurity

33
32
312 } 31
311
2
1

FIG. 16

FIG. 17

**101**

FIG. 18

**101**

FIG. 19

101

L

41 42 43

P-type
impurity

33

32

313
312 } 31
311

1

FIG. 20

101

L

41 42 43

P-type
impurity

33

32

313
312 } 31
311

1

FIG. 21

Form a first nucleation layer on a substrate containing silicon, where the first nucleation layer includes a group IIIA nitride doped with a P-type impurity — S11

Form a second nucleation layer on the first nucleation layer, where the second nucleation layer includes a group IIIA nitride doped with a P-type impurity, and the P-type impurity contains an element in group II and/or at least one element in IVA — S12

Form a channel layer on the second nucleation layer — S13

Form a barrier layer on the channel layer — S14

FIG. 22

**P-type impurity** ⎯⎯⎯⎯⎯⎯⎯⎯ 311

⎯ 1

FIG. 23a

**P-type impurity** ⎯⎯⎯⎯⎯⎯⎯⎯ 312 } 31
311

⎯ 1

FIG. 23b

**P-type impurity** ⎯⎯⎯⎯⎯⎯⎯⎯ 32

312 } 31
311

⎯ 1

FIG. 23c

33

**P-type impurity** ⎯⎯⎯⎯⎯⎯⎯⎯ 32

312 } 31
311

⎯ 1

FIG. 23d

41      42      43

33

**P-type impurity** ⎯⎯⎯⎯⎯⎯⎯⎯ 32

312 } 31
311

⎯ 1

FIG. 23e

| Form a diffusion barrier layer on a substrate containing silicon | S21 |

| Form a first nucleation layer on the diffusion barrier layer, where the first nucleation layer includes a group IIIA nitride doped with a P-type impurity | S22 |

| Form a second nucleation layer on the first nucleation layer, where the second nucleation layer includes a group IIIA nitride doped with a P-type impurity, and the P-type impurity contains an element in group II and/or at least one element in IVA | S23 |

| Form a channel layer on the second nucleation layer | S24 |

| Form a barrier layer on the channel layer | S25 |

FIG. 24

**P-type impurity**

FIG. 25a

FIG. 25b

FIG. 25c

FIG. 25d

FIG. 25e
~
TO
FIG. 25f

CONT.
FROM
FIG. 25e
~

**41**   **42**   **43**

P-type
impurity

33
32
312 }
311 } 31
2
1

FIG. 25f

| INTERNATIONAL SEARCH REPORT | International application No. |
| --- | --- |
| | **PCT/CN2023/100027** |

| A. | CLASSIFICATION OF SUBJECT MATTER |
| --- | --- |

H01L21/335(2006.01)i; H01L29/778(2006.01)i; H01L29/36(2006.01)i

According to International Patent Classification (IPC) or to both national classification and IPC

| B. | FIELDS SEARCHED |
| --- | --- |

Minimum documentation searched (classification system followed by classification symbols)

IPC:H01L

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI; IEEE: 第一, 第二, 成核层, 扩散, 缓冲, 沟道层, 势垒层, 氮化物, 浓度, 厚度, 镁, 碳, 硅, 铍, 钙, 锌, 位错, 摇摆曲线, first, second, nucleation layer, diffuse, buffer, channel, barrier, nitride, concentration, thickness, magnesium, Mg, carbon, silicon, Si, beryllium, Be, calcium, Ca, zinc, Zn, dislocation, rocking curve

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 114551563 A (DYNAX SEMICONDUCTOR INC.) 27 May 2022 (2022-05-27) description, paragraphs 44-70, and figures 2 and 5 | 1-20 |
| X | CN 111009468 A (PEKING UNIVERSITY et al.) 14 April 2020 (2020-04-14) description, paragraphs 47-76, and figure 1 | 1, 9, 13, 20 |
| A | CN 1692499 A (EMCORE CORP.) 02 November 2005 (2005-11-02) entire document | 1-20 |
| A | US 2014264441 A1 (RENESAS ELECTRONICS CORP.) 18 September 2014 (2014-09-18) entire document | 1-20 |
| A | CN 111477536 A (HUAWEI TECHNOLOGIES CO., LTD.) 31 July 2020 (2020-07-31) entire document | 1-20 |
| A | CN 104465720 A (SUN YAT-SEN UNIVERSITY) 25 March 2015 (2015-03-25) entire document | 1-20 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **07 September 2023** | **11 September 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**Information on patent family members**

International application No.

**PCT/CN2023/100027**

| Patent document cited in search report | | | Publication date (day/month/year) | Patent family member(s) | | | Publication date (day/month/year) |
|---|---|---|---|---|---|---|---|
| CN | 114551563 | A | 27 May 2022 | None | | | |
| CN | 111009468 | A | 14 April 2020 | None | | | |
| CN | 1692499 | A | 02 November 2005 | EP | 1568083 | A2 | 31 August 2005 |
| | | | | EP | 1568083 | A4 | 14 July 2010 |
| | | | | KR | 20050084774 | A | 29 August 2005 |
| | | | | KR | 100773997 | B1 | 08 November 2007 |
| | | | | AU | 2003298891 | A1 | 23 June 2004 |
| | | | | WO | 2004051707 | A2 | 17 June 2004 |
| | | | | WO | 2004051707 | A3 | 17 February 2005 |
| | | | | DE | 10392313 | T5 | 06 October 2005 |
| | | | | DE | 10392313 | B4 | 10 July 2014 |
| | | | | US | 2004119063 | A1 | 24 June 2004 |
| | | | | US | 7115896 | B2 | 03 October 2006 |
| | | | | TW | 200428652 | A | 16 December 2004 |
| | | | | TWI | 249246 | B | 11 February 2006 |
| | | | | JP | 2005527988 | A | 15 September 2005 |
| | | | | JP | 4095066 | B2 | 04 June 2008 |
| | | | | US | 2006154455 | A1 | 13 July 2006 |
| | | | | AU | 2003298891 | A8 | 02 November 2005 |
| US | 2014264441 | A1 | 18 September 2014 | US | 9401413 | B2 | 26 July 2016 |
| | | | | US | 2016293746 | A1 | 06 October 2016 |
| | | | | US | 9837518 | B2 | 05 December 2017 |
| | | | | JP | 2014179546 | A | 25 September 2014 |
| | | | | JP | 6174874 | B2 | 02 August 2017 |
| CN | 111477536 | A | 31 July 2020 | WO | 2021196974 | A1 | 07 October 2021 |
| | | | | JP | 2023519409 | A | 10 May 2023 |
| | | | | EP | 4113580 | A1 | 04 January 2023 |
| | | | | US | 2023026388 | A1 | 26 January 2023 |
| CN | 104465720 | A | 25 March 2015 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210682633X